# EUROPÄISCHE PATENTANMELDUNG

(11) **EP 3 671 820 A1**
(43) Veröffentlichungstag der Anmeldung: **24.06.2020**
(21) Anmeldenummer: 20153393.2
(22) Anmeldetag: 23.12.2014
(51) Int. Cl.: H01L 21/67

(54) **VERFAHREN UND VORRICHTUNG ZUR VORFIXIERUNG VON SUBSTRATEN**

(62) Teilanmeldung aus: 14816316.5
(71) Anmelder: EV Group E. Thallner GmbH, 4782 St. Florian am Inn (AT)
(72) Erfinder: LINDNER, Friedrich Paul, 4780 Schärding (AT)
(74) Vertreter: Schneider, Sascha

(57) **Zusammenfassung**

Die vorliegende Erfindung betrifft ein Verfahren und eine Vorrichtung zur Vorfixierung von Substraten (1, 2).

## Beschreibung

Die vorliegende Erfindung betrifft ein Verfahren und eine Vorrichtung gemäß den nebengeordneten Anspüchen.

In den Druckschriften US6563133B1 und US7332410B2 ist das Bonden von oxidfreien Substratpaaren bei Raumtemperatur ohne externe Kraftaufwendung offenbart. Dabei werden die Substratoberflächen durch Plasmabehandlung oder Ionenimplantation modifiziert, indem die Oberflächen mit einer semiamorphen Schicht aus Bor- oder Arsenionen behandelt werden. Nach dem vollflächigen Kontaktieren unter Normaldruck verbleiben die Substratpaare in einer leichten Vakuumatmosphäre. Eine Bindungsenergie von ca. 400 mJ/m² wird bei Raumtemperatur erreicht. Um ein Permanentbond zu erzeugen, folgt noch ein Annealing-Schritt bei bis zu 400°C. Die Substrate beschränken sich auf Halbleiter wie Si, InGaAs, GaAs, Ge und SiC.

Die Druckschrift EP2672509A1 zeigt ein Cluster-System mit einer Vorbehandlungseinheit und einer Bondeinheit. Dabei sollen Bondoberflächen hergestellt werden, die ohne hohes Vakuum ein Bonden mit genügender Bondkraft erlauben.

Die Druckschrift US2006/0132544A1 beschreibt das Heften (engl. "tacking") beziehungsweise Vorfixieren einer Verbundfolie, die eine Klebeschicht besitzt. Durch einen Laser werden Teilbereiche der Kleberschicht erhitzt und dadurch wird das Heften ermöglicht.

Die Druckschrift US5686226 verwendet einen lokal angebrachten Harzkleber zum Heften von (Produkt)Substraten miteinander durch Aushärtung (Polymerisation) des Klebers mittels UV-Strahlung.

Insbesondere der Transport von Substraten oder Substratstapeln bereitet im Stand der Technik erhebliche Probleme, da die Substrate einerseits nicht beschädigt werden sollen und andererseits eine etwaige Ausrichtung der Substrate nicht verändert werden soll. Weiterhin soll der Transport auf möglichst kleinem Raum erfolgen.

Aufgabe der vorliegenden Erfindung ist es daher, ein Verfahren und eine Vorrichtung anzugeben, mit welchen insbesondere der Transport der ausgerichteten Substrate verbessert wird. Weiterhin soll die Bondqualität erhöht und weniger Ausschuss erzeugt werden. Darüber hinaus sollen die Flexibilität verbessert und die Durchlaufzeiten verringert werden.

Diese Aufgabe wird mit den Merkmalen der nebengeordneten Patentansprüche gelöst. Vorteilhafte Weiterbildungen der Erfindung sind in den Unteransprüchen angegeben. In den Rahmen der Erfindung fallen auch sämtliche Kombinationen aus zumindest zwei von in der Beschreibung, den Ansprüchen und/oder den Figuren angegebenen Merkmalen. Bei angegebenen Wertebereichen sollen auch innerhalb der genannten Grenzen liegende Werte als Grenzwerte offenbart gelten und in beliebiger Kombination beanspruchbar sein.

Die Grundidee der vorliegenden Erfindung ist es, Substraten, bei welchen mindestens eine Substratoberfläche der Substrate in mindenstens einem Oberflächenbereich vorbehandelt, insbesondere amorphisiert, ist, die Substrate auszurichten und anschließend an den vorbehandelten Oberflächenbereichen zu kontaktieren und vorzufixieren. Die Ausrichtung und Kontaktierung sowie Vorfixierung erfolgt vorzugsweise in ein und derselben, insbesondere während der Ausrichtung und Kontaktierung ununterbrochen vakuumbeaufschlagten, Modulkammer (Vorfixierungsmodul).

Gemäß einer vorteilhaften Ausführungsform der Erfindung werden die Substrate anschließend gebondet, insbesondere ohne Unterbrechung des Vakuums in der Modulkammer. In einer bevorzugten Hochvakuumumgebung (insbesondere <10e⁻⁷ mbar, bevorzugt <10e⁻⁸ mbar) bonden polierte und/oder vorbehandelte Substratoberflächen spontan und kovalent durch reine Kontaktierung ohne zusätzlichen Druck (oder zumindest nur sehr geringen Druck), insbesondere bei Raumtemperatur. Auf die Druckschrift PCT/EP 2014/063303 wird in Bezug auf die Vorbehandlung Bezug genommen.

Das erfindungsgemäße Verfahren, die davon abgeleitete Vorrichtung und daraus hergestellte Artikel nutzten die Effekte der Vorbehandlung insbesondere, um Substratpaare in einer Justiereinheit (Ausrichtungseinrichtung, insbesondere außerhalb der Bondkammer) vorzufixieren, ohne dabei die hohe Kontaktkräfte und/oder hohe Temperaturen zu verwenden, wie sie bei vollflächigen permanenten Bonds notwendig wären. Vorzugsweise werden die Substrate ausschließlich an einigen wenigen Punkten beziehungsweise Teilflächen (Oberflächenbereiche) vorfixiert beziehungsweise temporär gebondet.

Erst in einem nachfolgenden Bondschritt (in der Bondkammer eines Bondmoduls) werden höhere Kräfte mit einer gleichmäßigen Flächenlast aufgebracht. Dieser Prozess kann durch einen zusätzlichen Temperatureintrag unterstützt werden.

Die Vorbehandlung erfolgt insbesondere in einem von dem Vorfixierungsmodul und/oder dem Bondmodul, insbesondere durch Schleusen, trennbaren Vorbehandlungsmodul. In diesem wird eine amorphisierte Substratoberfläche der Substrate (Halbleitermaterial, Oxide oder polierte Metalle wie Al, Cu, Glas, Keramiken) erzeugt. Die Substrate werden aktiviert und ein hoher Anteil an Mikrokontaktflächenberührungen bei Kontakt zweier Substrate wird ermöglicht. Es können sich dadurch spontane, kovalente Bonds bei geringen Temperaturen, insbesondere bei Raumtemperatur, ausbilden. Bevorzugt erfolgt die Kontaktierung im Hochvakuum.

Die Vorfixierung erfolgt insbesondere durch lokale Energiezufuhr, insbesondere von einer der zu kontaktierenden Substratoberfläche abgewandten Seite her.

Um einen äquivalenten Druck für spontane Bonds in Teilflächen zu erreichen und die Substrate, insbesondere Wafer, vorzufixieren (zu heften oder "tacken"), erfolgt vorzugsweise ein lokales Aufbringen von Energie, insbesondere Kraft und/oder Wärme. Die Substrate werden lokal, insbesondere mit einem oder mehreren Druckstempeln, beaufschlagt und damit lokal vorfixiert. Die, insbesondere dreiachsige, Justiereinheit wird vorzugsweise nur für die resultierende Kraft der Teilbeaufschlagung ausgelegt, so dass diese weniger aufwendig und somit kostengünstiger sind.

An den beaufschlagten Oberflächenbereichen entsteht ein, insbesondere kovalenter, Bond (Vorfixierung), der stark genug ist, um das vorfixierte Substratpaar in die Bondkammer zu transferieren. Dort erfolgt eine ganzflächige Druckbeaufschlagung zum permanenten Bonden mit optionalem Ausheizen.

Die Bondstärke der Vorfixierung ist insbesondere so stark, dass die Substrate während dem Transport ihre gegenseitige Ausrichtung behalten.

Für die Handhabung, insbesondere den Transport von dem Ausrichtungsmodul beziehungsweise Vorfixierungsmodul zu dem Bondmodul oder anderen Bearbeitungsmodulen kann insbesondere auf eine Aufnahmeeinrichtung (Substrathalter beziehungsweise Chuck) auf einer der beiden oder auf beiden Halteseiten (von den Substratoberflächen abgewandte Seiten) des Substratstapels verzichtet werden.

In Weiterbildung der Erfindung ist es vorgehsenen, dass mindestens eine der Substratoberflächen, vorzugsweise alle, einen Mittenrauwert Ra kleiner als 20 nm, bevorzugter einen Mittenrauwert Ra kleiner als 1 nm, aufweist. Für alle polierten Oberflächen mit einem Mittenrauwert Ra kleiner als 20nm (wie insbesondere Aluminium, Kupfer, Oxide, Halbleitermaterialien und Glas) ist eine Vorfixierung durch lokalen Krafteintrag in der Justiereinrichtung möglich.

Eine Ausführungsform des erfindungsgemäßen Verfahrens weist insbesondere folgende Schritte auf:
1) Einbringen von Substraten oder eines Substratpaars in eine Hochvakuumumgebung, insbesondere durch eine Schleuse, und Transfer (insbesondere eines Roboterarms) mindestens eines der Substrate in eine Vorbehandlungskammer eines Vorbehandlungsmoduls,
2) Vorbehandeln mindestens eines der Substrate derart, damit diese sich für spontane Raumtemperaturbonds eignen,
3) Transfer (insbesondere des Roboterarms) zu einer Justiereinrichtung/Ausrichtungseinrichtung/Vorfixierungsmodul (erste Modulkammer),
4) Ausrichtung der beiden Substrate zueinander in der Ausrichtungseinrichtung,
5) Kontaktieren der beiden Substrate und lokale Beaufschlagung mit Energie, insbesondere einer oder mehreren lokalen Flächenlasten; Dadurch erfolgt eine Vorfixierung, so dass die Ausrichtung der Substrate zueinander fix ist. Alternativ kann auch vollflächig vorfixiert werden,
6) Transfer (insbesondere des Roboterarms) des vorfixierten Substratstapels in ein Bondmodul (zweite Modulkammer),
7) teil- oder (bevorzugt) vollflächiges Aufbringen einer Bondkraft und optionales Aufheizen zur weiteren Festigung der Verbindung und
8) Ausschleusen der gebondeten Substrate aus der Hochvakuumumgebung.

Gemäß einer Ausführungsform der Erfindung kann das Verfahren nach dem Schritt 5 gegebenenfalls mehrfach wiederholt werden, um weitere Substrate zu dem Substratstapel hinzuzufügen, bevor gebondet wird.

Die erfindungsgemäße Methode wird mit Vorzug in einer durch Schleusen schließbaren Hochvakuum-, bevorzugt Ultrahochvakuumumgebung, angewendet. Innerhalb der Hochvakuumumgebung sind die, insbesondere zusätzlich mit Druck beaufschlagbaren, Module angeordnet.

Gemäß einem Aspekt der Erfindung erfolgt eine Trennung der (Präzisions-)Ausrichtung von dem beim Bonden erfolgenden hohen Krafteintrag und gegebenenfalls hoher Temperatur. Hieraus ergeben sich konstruktive Vorteile, die zu einer Kosteneinsparung führen. Schon Kräfte größer als 1 kN entlang einer Z-Achse würden eine Präzisionsmechanik zur Justierung im Sub-µm Bereich entlang einer X- und Y-Achse, insbesondere im Hochvakuum, extrem aufwendig, wenn nicht unmöglich, machen. So sind beispielsweise im Hochvakuum keine Schmiermittel erlaubt und auch keine Luftlager. Rollende und gleitende Lager verursachen Partikel beziehungsweise auch hohes Umkehrspiel durch Reibkräfte. Weiterhin verursacht das Einleiten einer hohen Kraft entlang einer Z-Achse ein hohes Risiko, die X-Y-Ausrichtung und damit die Ausrichtungsgenauigkeit negativ zu beeinflussen.

Ein weiterer Vorteil ist die optimale Produktivität. So können beispielsweise in einer Anlage die Anzahl der Vorfixiereinrichtungen und Bondmodule so gewählt werden, dass ein optimaler Durchsatz für jeweiligen Prozess gewährleistet ist. Insbesondere bei nötigem Temperatureintrag und den damit verbundenen Heiz- und Kühlzeiten ist es bevorzugt, mit einer Vorfixiereinheit mehrere Bondmodule zu bedienen.

Ein weiterer Vorteil der Erfindung ist die Modularität und damit Nachrüstbarkeit der Vorfixiereinheit. Mit lokal vorgebondeten Substraten, die in einer Justiereinheit mit Vorfixierung vorfixiert/getackt werden, lässt sich eine Hochvakuumanlage durch Zufügen einer erfindungsgemäßen Vorfixiereinheit nachrüsten.

Der Mittenrauwert beziehungsweise arithmetischer Mittenrauwert Ra beschreibt die Rauheit einer technischen Oberfläche. Zur Ermittlung dieses Messwertes wird die Oberfläche auf einer definierten Messstrecke abgetastet und sämtliche Höhen- und Tiefenunterschiede der rauen Oberfläche aufgezeichnet. Nach der Berechnung des bestimmten Integrals dieses Rauheitsverlaufes auf der Messstrecke wird abschließend dieses Ergebnis durch die Länge der Messstrecke dividiert. Die Spanne der Rauheitswerte reicht von 25 µm bei sehr rauen Flächen mit spürbaren Riefen bis hin zu <20 nm für polierte Oberflächen.

Vorteilhafte Materialkombinationen für die Substrate sind Kombinationen aus allen Materialien, die eine polierte oder polierbare Oberfläche aufweisen, vorzugsweise mit einem Mittenrauwert Ra kleiner als 20 nm. Bevorzugt sind die nachfolgenden Materialien oder Kombinationen von Materialien:
- Halbleitermaterialien, insbesondere Si, InP, GaAs, Halbleiterlegierungen, III-V- und II-IV-Verbindungen,
- Metalle, insbesondere Cu, Al,
- Oxide, insbesondere SiO₂ oder andere Oxide von Halbleitermaterialien oder Halbieiterwafer mit Oxidierter Oberfläche,
- Nitride, insbesondere SiNx,
- Glas,
- Glaskeramiken insbesondere Zerodur®,
- Keramik.

Die Erfindung ist insbesondere auf polierte Oberflächen beschränkt, die eine Vorbehandlung für kovalente Bonds erlauben. Das sind vorzugsweise Oberflächen mit einem Mittenrauwert Ra kleiner als 20 nm, bevorzugter mit einem Ra kleiner als 1 nm, gemessen auf einem 2x2 µm² Feld mit einem Rasterkraftmikroskop (engl. Atomic Force Microscope, AFM). Der lokale Energieeintrag oder Krafteintrag ist insbesondere so groß, um Mikrorauheiten ausreichend zu egalisieren, damit ein hoher Anteil an Oberflächenmolekülen zwischen den Substraten wirkende Bindungsenergien aufbauen kann. Je geringer der mittlere Abstand der Oberflächen zweier Substrate auf atomarer Ebene ist, desto größer ist die Adhäsion. Die Adhäsion hängt demnach von der Rauheit der zu kontaktierenden Oberflächen der Substrate ab.

Durch Plasmabehandlung können die Substratoberflächen vorbehandelt werden, wobei sich die Mikrorauheit der Substratoberflächen (topologische Strukturen) verändert. Bei Erreichen einer optimalen Oberflächenrauheit können maximale Bondenergien erzielt werden.

Ein Teilaspekt einer Ausführungsform oder Weiterbildung der vorliegenden Erfindung, insbesondere betreffend die Vorbehandlung, ist in der PCT/EP2014/063303 offenbart und auf diese Offenbarung wird Bezug genommen. PCT/EP2014/063303 beschreibt ein Verfahren und eine Vorrichtung zur Oberflächenbehandlung von Substraten. Die Grundidee von PCT/EP2014/063303 ist es, eine überwiegend amorphisierte Schicht an einer zu bondenden Substratoberfläche zu erzeugen. Die Amorphisierung der Substratoberfläche führt zu einem besseren Bondergebnis, insbesondere bei vergleichsweise geringen Temperaturen. Bevorzugt erfolgen eine Reinigung der Oberfläche zur Oxidentfernung und eine Amorphisierung gleichzeitig. Die PCT/EP2014/063303 betrifft insbesondere eine Methode zum permanenten Bonden zweier Substrate, wovon wenigstens eines, vorzugsweise beide wie nachfolgend beschrieben vor derm Bonden behandelt wurde. Oberflächenbereiche, insbesondere eine Kontaktseite (vorzugsweise vollflächig) der beiden oder wenigstens eines der beiden Substrate werden vor dem Bondvorgang amorphisiert. Durch die Amorphisierung wird eine nanometerdicke Schicht erzeugt, in der die Atome mindestens einer der zu verbondenden Oberflächen (Kontaktseiten) regellos angeordnet werden. Diese regellose Anordnung führt zu einem besseren Bondergebnis, insbesondere bei vergleichsweise geringen Temperaturen. Zur Erzeugung eines erfindungsgemäßen Bonds wird insbesondere eine Reinigung der Oberflächen (zumindest der Kontaktseiten), insbesondere zur Befreiung von Oxiden, durchgeführt. Vorzugsweise erfolgt Reinigung und Amorphisierung gleichzeitig, noch bevorzugter durch dieselbe Behandlung. Ein wesentlicher erfindungsgemäßer Aspekt der Erfindung ist insbesondere die Verwendung niederenergetischer Teilchen, insbesondere Ionen, deren Energie vergleichsweise niedrig ist, allerdings ausreicht, um die erfindungsgemäß beschriebene Amorphisierung zu bewirken.

Die Entfernung des Oxids von den Substratoberflächen ist für einen optimalen Bondprozess und einen Substratstapel mit entsprechend hoher Bondstärke vorteilhaft. Dies gilt insbesondere für alle Materialien, bei denen eine sauerstoffhaltige Atmosphäre ein ungewolltes, natives Oxid bildet. Dies gilt nicht notwendigerweise für bewusst erzeugte Sauerstoffsubstratoberflächen wie beispielsweise für Siliziumoxid. Insbesondere werden erfindungsgemäß, vorzugsweise zumindest überwiegend, noch bevorzugter ausschließlich, schädliche, unnötige und/oder native, insbesondere metallische, Oxide entfernt. Vorzugsweise werden die vorgenannten Oxide vor einem Bondvorgang weitestgehend, insbesondere vollständig, entfernt, um nicht in die Bondgrenzfläche (Kontaktfläche zweier Substrate) eingebaut zu werden. Ein Einbau derartiger Oxide würde zu einer mechanischen Destabilisierun und zu einer sehr geringen Bondstärke führen. Die Entfernung des Oxids erfolgt durch physikalische oder chemische Verfahren. In einer besonders bevorzugten erfindungsgemäßen Ausführungsform erfolgt die Entfernung der ungewollten Oxide mit derselben Vorbehandlungseinrichtung, mit der die Vorbehandlung ausgeführt wird. Dadurch können, insbesondere unter optimalen Umständen:
- Oxidentfernung
- Oberflächenglättung
- Amorphisierung
gleichzeitig durchgeführt werden. In alternativen erfindungsgemäßen Ausführungsformen erfolgt die Oxidentfernung nicht in derselben Anlage. Dabei muss insbesondere sichergestellt werden, dass es zu keiner erneuten Oxidation der Substratoberflächen beim Transfer der Substrate zwischen den beiden Anlagen kommt.

In der Halbleiterindustrie werden bereits seit mehreren Jahren unterschiedliche Bondtechnologien verwendet, um Substrate miteinander zu verbinden. Den Verbindungsvorgang nennt man Bonden. Man unterscheidet zwischen Temporärbondverfahren und den Permanentbondverfahren.

Bei den Temporärbondverfahren wird ein Produktsubstrat mit einem Trägersubstrat so gebondet, dass es nach einer Prozessierung wieder gelöst werden kann. Mit Hilfe der Temporärbondverfahren ist es möglich, ein Produktsubstrat mechanisch zu stabilisieren. Die mechanische Stabilisierung garantiert, dass sich das Produktsubstrat handhaben lässt, ohne sich zu wölben, zu verformen oder zu brechen. Stabilisierungen durch Trägersubstrate sind insbesondere während und nach einem Rückdünnprozess notwendig. Ein Rückdünnprozess erlaubt die Reduzierung der Produktsubstratdicke auf wenige Mikrometer.

Bei den Permanentbondverfahren werden zwei Substrate dauerhaft, d.h. permanent, gebondet. Das permanente Bonden erlaubt auch die Herstellung von mehrlagigen Strukturen (mehr als zwei Substrate). Diese mehrlagigen Strukturen können aus demselben oder aus unterschiedlichen Materialien bestehen. Es existieren unterschiedliche Permanentbondverfahren.

Das Permanentbondverfahren des anodischen Bondens wird insbesondere verwendet, um ionenhaltige Substrate permanent miteinander zu verbinden. Bevorzugt handelt es sich bei einem der beiden Substrate um ein Glassubstrat. Das zweite Substrat ist vorzugsweise ein Siliziumsubstrat. Beim anodischen Bonden wird ein elektrisches Feld entlang der beiden miteinander zu bondenden Substrate angelegt. Das elektrische Feld wird zwischen zwei Elektroden, die vorzugsweise die beiden Oberflächen der Substrate kontaktieren, erzeugt. Das elektrische Feld erzeugt einen Ionentransport im Glassubstrat und bildet eine Raumladungszone zwischen den beiden Substraten aus. Die Raumladungszone bewirkt eine starke Anziehung der Oberflächen beider Substrate, die nach der Annäherung miteinander kontaktieren und damit eine bleibende Verbindung ausbilden. Der Bondvorgang beruht also vorwiegend auf der Maximierung der Kontaktfläche beider Oberflächen.

Ein weiteres Permanentbondverfahren ist das eutektische Bonden. Beim eutektischen Bonden wird eine Legierung mit einer eutektischen Konzentration erzeugt, oder die eutektische Konzentration stellt sich während eines Prozesses, insbesondere einer Wärmebehandlung, ein. Durch das Überschreiten der eutektischen Temperatur (der Temperatur bei der sich die flüssige Phase mit den festen Phasen des Eutektikums im Gleichgewicht befindet) schmilzt das Eutektikum vollständig auf. Die erzeugte flüssige Phase der eutektischen Konzentration benetzt die Oberfläche der noch nicht verflüssigten Bereiche. Beim Erstarrungsvorgang erstarrt die flüssige Phase zum Eutektikum und bildet die Verbindungsschicht zwischen den beiden Substraten.

Ein weiteres Permanentbonderfahren ist das Fusionsbonden. Beim Fusionsbonden werden zwei ebene, reine Substratoberflächen durch Kontaktierung gebondet. In einem ersten Schritt erfolgt eine Kontaktierung der beiden Substrate, wobei eine Fixierung der beiden Substrate durch vander-Waals-Kräfte stattfindet. Die Fixierung bezeichnet man als Vorbond oder Vorfixierung (engl.: pre-bond). Die Bondkraft des Vorbonds erlaubt die Herstellung einer Vorfixierung, die stark genug ist, um die Substrate so fest zu bonden, dass eine gegenseitige Verschiebung, insbesondere durch das Aufbringen einer Scherkraft, nur mehr mit erheblichem Kraftaufwand möglich ist. Bevorzugt können die beiden Substrate, insbesondere durch Anlegen einer Normalkraft, wieder relativ leicht voneinander getrennt werden. Um einen permanenten Fusionsbond zu erzeugen, werden die Substratstapel einer Wärmebehandlung unterzogen. Die Wärmebehandlung führt zur Ausbildung kovalenter Verbindungen zwischen den Oberflächen der beiden Substrate. Ein derartiger erzeugter Permanentbond ist nur mehr durch die Aufwendung einer hohen, mit einer Zerstörung der Substrate einhergehenden, Kraft möglich.

Soweit die gebondeten Substrate mit funktionalen Einheiten, insbesondere Mikrochips, MEMs, Sensoren, LEDs, bestückt sind, wird bevorzugt bei niedrigen Temperaturen, insbesondere kleiner 200 °C, vorzugsweise bei Raumtemperatur, vorfixiert und/oder gebondet. Bevorzugt wird eine Temperatur gewählt, die unterhalb einer Temperaturempfindlichkeitsgrenze der funktionalen Einheiten liegt. Insbesondere Mikrochips besitzen eine relativ starke Dotierung. Die Dotierelemente besitzen bei erhöhten Temperaturen eine erhöhte Diffusionsfähigkeit, die zu einer ungewollten, nachteiligen Verteilung der Dotierungen im Substrat führen kann. Durch diese Maßnahme können thermische Spannungen minimiert werden. Darüber hinaus werden die Prozesszeiten für das Aufheizen und Abkühlen verkürzt. Des Weiteren werden Verschiebungen unterschiedlicher Substratbereiche reduziert, die aus unterschiedlichen Materialien bestehen, insbedondere auch unterschiedliche thermische Ausdehnungskoeffizienten haben.

In Weiterbildung hierzu findet eine Plasmabehandlung zur Reinigung und Aktivierung einer Substratoberfläche statt, um bei geringen Temperaturen bonden zu können, insbesondere soweit keine sauerstoffaffinen Oberflächen, insbesondere Metalloberflächen, verwendet werden. Bevorzugt wird dagegen monokristallines Silizium, welches eine Siliziumdioxidschicht ausbildet. Die Siliziumdioxidschicht eignet sich hervorragend zum Bonden.

Im Stand der Technik existieren mehrere Ansätze für das Direktbonden bei niedrigerer Temperatur. Ein Ansatz in der PCT/EP2013/064239 besteht im Aufbringen einer Opferschicht, die während und/oder nach dem Bondprozess im Substratmaterial gelöst wird. Ein weiterer Ansatz in der PCT/EP2011/064874 beschreibt die Herstellung einer permanenten Verbindung durch Phasenumwandlungen. Die genannten Druckschriften beziehen sich insbesondere auf metallische Oberflächen, die eher über eine Metallbindung und nicht über kovalente Bindungen gebondet werden. In der PCT/EP2014/056545 wird ein optimierter Direktbondvorgang von Silizium durch eine Oberflächenreinigung beschrieben. Die genannten Verfahren können mit der vorliegenden Erfindung kombiniert werden und insofern wird auf die Offenbarung der vorgenannten Druckschriften verwiesen.

Gemäß einer vorteilhaften Ausführungsform der Erfindung sollen insbesondere sortengleiche Werkstoffe beziehungsweise Materialien miteinander verbunden (gebondet) werden. Die Sortengleichheit sorgt dafür, dass an den Kontaktflächen der Substratoberflächen (Bond-Interface) gleiche physikalische und chemische Eigenschaften vorhanden sind. Das ist insbesondere wichtig für Verbindungen, über die elektrischer Strom geleitet werden soll, die geringe Korrosionsneigung und/oder gleiche mechanische Eigenschaften aufweisen sollen. Bevorzugte sortengleiche Werkstoffe sind:
- Kupfer-Kupfer,
- Aluminium-Aluminium,
- Wolfram-Wolfram,
- Silizium-Silizium,
- Siliziumoxid-Siliziumoxid.

Ein weiterer Aspekt der vorliegenden Erfindung besteht insbesondere darin, die Fähigkeit unterschiedlicher Materialien, insbesondere Metalle und/oder Oxide, sich unter externen Einflüssen, insbesondere Temperatur und/oder Druck, zu verbinden auszunutzen, um eine lokale, insbesondere örtlich stark begrenzte, Vorfixierung zwischen den Substraten zu erhalten. Dies wird auch als "tacking" bezeichnet. Das erfindungsgemäße Verfahren wird bevorzugt für Substrate mit amorphisierten Schichten verwendet. Die amorphisierte Schicht kann dabei durch chemische und/oder physikalische Abscheideprozesse auf der Substratoberfläche aufgebracht oder direkt auf der Substratoberfläche erzeugt werden. Ein, insbesondere eigenständiger, Aspekt der Erfindung besteht darin, dass die amorphisierte Schicht nicht durch ein mittels physikalischer und/oder chemischer Prozesse aufgebrachtes Material, sondern durch eine Phasenumwandlung des Substratmaterials erzeugt wird. Dadurch kann auf die Abscheidung eines, insbesondere ungewollten oder schädlichen, Materials vollständig verzichtet werden.

Im Folgenden werden weitere Ausführungsformen der erfindungsgemäßen Verfahrensschritte offenbart:

### Vorbehandlung der Substratoberflächen

Die Erfindung betrifft insbesondere eine Methode zum Tacken mindestens zweier Substrate, wovon wenigstens eines, vorzugsweise beide, wie nachfolgend beschrieben vor dem Tacken behandelt wurden.

Oberflächenbereiche, insbesondere eine Kontaktseite (vorzugsweise vollflächig) der beiden oder wenigstens eines der beiden Substrate werden vor dem Bondvorgang amorphisiert. Erfindungsgemäß kann auch die Amorphisierung von, insbesondere voneinander getrennten, Oberflächenbereichen, die kleiner sind als die Substratoberfläche, erfolgen.

Durch die Amorphisierung wird eine einige Manometer dicke Schicht erzeugt, in der die Atome regellos angeordnet sind. Die regellose Anordnung führt zu einem besseren Bondergebnis, insbesondere bei vergleichsweise geringen Temperaturen.

Zur Erzeugung eines erfindungsgemäßen Bonds und/oder Vorfixierung wird insbesondere eine Reinigung der Substratoberflächen (zumindest der Kontaktseiten), insbesondere zur Befreiung von Oxiden, durchgeführt. Vorzugsweise erfolgen Reinigung und Amorphisierung gleichzeitig, noch bevorzugter durch dieselbe Behandlung.

Ein weiterer Aspekt der Erfindung ist insbesondere die Verwendung niederenergetischer Teilchen, insbesondere Ionen, deren Energie beim Auftreffen auf die Substratoberfläche so eingestellt wird, um die erfindungsgemäß beschriebene Amorphisierung zu bewirken.

Bevorzugt wird ein Schritt zur Entfernung eines Oxids von den Substratoberflächen durchgeführt. Dies gilt insbesondere für Materialien, bei denen eine sauerstoffhaltige Atmosphäre ein natives Oxid bildet, jedoch nicht für erfindungsgemäß erzeugte Sauerstoffsubstratoberflächen wie insbesondere für Siliziumoxid. Insbesondere werden erfindungsgemäß, vorzugsweise zumindest überwiegend, noch bevorzugter ausschließlich, schädliche, unnötige und/oder native, insbesondere metallische, Oxide entfernt. Vorzugsweise werden die vorgenannten Oxide vor einem Bondvorgang weitestgehend, insbesondere vollständig, entfernt, um nicht in die Bondgrenzfläche (Kontaktfläche zweier Substrate) eingebaut zu werden. Ein Einbau derartiger Oxide würde zu einer mechanischen Destabilisierung und zu einer sehr geringen Bondstärke führen. Die Entfernung des Oxids erfolgt insbesondere durch physikalische oder chemische Verfahren. In einer besonders bevorzugten erfindungsgemäßen Ausführungsform erfolgt die Entfernung der ungewollten Oxide mit demselben Vorbebandlungsmodul, mit dem die Vorbehandlung der Substrate durchgeführt wird. Dadurch können, insbesondere unter optimalen Umständen, Oxidentfernung, Oberflächenglättung und/oder Amorphisierung gleichzeitig durchgeführt werden. In alternativen erfindungsgemäßen Ausführungsformen erfolgt die Oxidentfernung nicht in derselben Anlage. Dabei muss insbesondere sichergestellt werden, dass es zu keiner erneuten Oxidation der Substratoberflächen beim Transfer der Substrate zwischen den beiden Anlagen kommt. Dies kann dadurch gewährleistet werden, dass das Hochvakuum während der Oxidentfernung, des Transports, der Vorbehandlung bis zum Bonden nicht unterbrochen wird.

Der erfindungsgemäße Gedanke besteht mit anderen Worten insbesondere in der effizienten, insbesondere lokal begrenzten, Vorfixierung durch Erhöhung der Bondfestigkeit zwischen zwei Substratoberflächen durch Amorphisierung. Die Amorphisierung löst dabei mehrere Probleme:
Die erfindungsgemäße Amorphisierung bewirkt insbesondere eine Planarisierung der Substratoberfläche. Die Planarisierung findet somit insbesondere während der Amorphisierung statt, insbesondere zusätzlich zu einer während des Bondvorgangs vorgesehenen Planarisierung durch Krafteinwirkung.

Die Amorphisierung gewährleistet außerdem eine höhere Beweglichkeit des Materials an den Grenzflächen. Dadurch kann eine etwaige Restrauheit besser ausgeglichen werden. Insbesondere können verbleibenden Lücken zwischen den Substratoberflächen geschlossen werden.

Durch die Amorphisierung wird insbesondere ein thermodynamisch metastabiler Zustand an der Substratoberfläche (Bondgrenzfläche) erzeugt.

Dieser metastabile Zustand führt in einem weiteren Prozessschritt (insbesondere nach Kontaktierung der zu bondenden Oberflächen) zu einer (Rück-)Umwandlung von Teilbereichen der amorphen Schicht in einen kristallinen Zustand. Im Idealfall erfolgt eine vollständige Umwandlung der amorphen Schicht. Die resultierende Schichtdicke nach der Kontaktierung und der anschließenden Wärmebehandlung der amorphen Schicht ist insbesondere größer als null.

Ein weiterer erfindungsgemäßer Gedanke besteht insbesondere in der Erzeugung der amorphen Schicht aus dem vorhandenen Grundmaterial des Substrats, insbesondere durch Teilchenbeschuss. Vorzugsweise wird vor dem Bonden der Substrate kein Material auf die zu kontaktierenden Substratoberflächen aufgebracht. Da die Vorfixierung der Substrate vorzugsweise nur an einigen wenigen Punkten erfolgt, besteht ein weiterer erfindungsgemäßer Gedanke darin, die Amorphisierung nur an den für die Vorfixierung vorgesehenen Punkten durchzuführen. Soweit die erfindungsgemäß durch Tacken vorfixierten Substrate in einem späteren Prozessschritt vollflächig gebondet werden, wird eine vollständige Amorphisierung bevorzugt.

Das erfindungsgemäße Verfahren erlaubt insbesondere die Herstellung eines vollständigen und/oder lokalen und/oder vollflächigen, insbesondere sortenreinen, Kontakts zweier Substratoberflächen, wovon mindestens eine, vorzugsweise beide, erfindungsgemäß amorphisiert sind.

Das erfindungsgemäße Verfahren wird insbesondere für die Herstellung eines vollständigen und/oder vollflächigen und/oder nicht sortenreinen Kontakts zweier, vorzugsweise unterschiedlicher, Substratoberflächen verwendet.

Insbesondere können folgende Materialien in beliebiger Kombination, vorzugsweise jeweils gleiche Materialien, miteinander vorfixiert werden:
- Metalle, insbesondere, Cu, Ag, Au, Al, Fe, Ni, Co, Pt, W, Cr, Pb, Ti, Te, Sn und/oder Zn,
- Legierungen
- Halbleiter (mit entsprechender Dotierung), insbesondere
   ∘ Elementhalbleiter, vorzugsweise Si, Ge, Se, Te, B und/oder α-Sn,
   ∘ Verbindungshalbleiter, insbesondere, GaAs, GaN, InP, InxGal-xN,InSb, InAs, GaSb, AlN, InN, GaP, BeTe, ZnO, CuInGaSe2, ZnS, ZnSe, ZnTe, CdS, CdSe, CdTe, Hg(1-x)Cd(x)Te, BeSe, HgS, AlxGal-xAs, GaS, GaSe, GaTe, InS, InSe, InTe, CuInSe², CuInS², CuInGaS², SiC und/oder SiGe,
- Organische Halbleiter, insbesondere, Flavanthron, Perinon, Alq3, Perinon, Tetracen, Chinacridon, Pentacen, Phthalocyanine, Polythiophene, PTCDA, MePTCDI, Acridon und/oder Indanthron.

Die Erfindung betrifft mit anderen Worten insbesondere eine Methode zum, insbesondere örtlich begrenzten, Direktbonden. Der Erfindung liegt dabei bevorzugt der Gedanke zugrunde, mindestens eine (insbesondere an der Kontaktseite angeordnete) Oberfläche beziehungsweise einen Teilbereich der Oberfläche eines Substrats vor dem Bondvorgang beziehungsweise der Vorfixierung zu amorphisieren. Die Amorphisierung erfolgt bevorzugt nicht durch das Abscheiden eines Materials, das unter den gegebenen Abscheideparametern an der Substratoberfläche amorph resublimiert beziehungsweise kondensiert, sondern insbesondere durch eine Änderung, Urformung und/oder Phasenumwandlung einer amorphen Schicht an der Substratoberfläche. Dies erfolgt insbesondere durch die Einbringung kinetischer Energie durch Teilchenbeschuss, insbesondere lonenbeschuss, am bevorzugtesten durch einen niederenergetischen lonenbeschuss.

Unter einem zumindest teilweise amorphen Gefüge der ausgebildeten amorphen Schicht wird insbesondere ein Phasengemenge verstanden, das zumindest aus einer amorphen Phase und einer kristallinen Phase besteht.

Das Volumenverhältnis zwischen der amorphen Phase und dem Gesamtvolumen soll als Amorphisierungsgrad bezeichnet werden. vorzugsweise größer als 25%, noch bevorzugter größer al 50%, am bevorzugtesten größer als 75%, am allerbevorzugtesten größer als 99%.

Die Amorphisierung wird insbesondere auf den oberflächennahen Bereich der miteinander zu verbondenden Substrate beschränkt, vorzugsweise durch Wahl der Prozessparameter Temperatur, Druck, Ionenenergie und/oder Ionenstromdichte während der Amorphisierung. Insbesondere bleibt das Material des Substrats dabei abgesehen von der erfindungsgemäß amorphisierten Schicht zumindest überwiegend, vorzugsweise vollständig, kristallin. In einer ersten erfindungsgemäßen Ausführungsform wird nur die Substratoberfläche beziehungsweise ein Teil der Substratoberfläche eines ersten Substrats amorphisiert. Die Dicke d der amorphen Schicht unmittelbar nach der erfindungsgemäßen Erzeugung in einer Substratoberfläche ist insbesondere kleiner als 100 nm, vorzugsweise kleiner als 50 nm, noch bevorzugter kleiner als 10 nm, am bevorzugtesten kleiner als 5 nm, am allerbevorzugtesten kleiner als 2 nm.

Gemäß einer erfindungsgemäßen Weiterbildung werden die Substratoberfläche eines ersten Substrats und die Substratoberfläche eines zweiten Substrats beziehungsweise werden Teilbereiche der Substratoberflächen amorphisiert. In einer besonderen erfindungsgemäßen Ausführungsform erfolgt die Amorphisierung beider Substratoberflächen in der gleichen Anlage, insbesondere gleichzeitig, um unter gleichen Prozessparametern gleiche amorphe Schichten zu erzeugen. Die erzeugten amorphen Schichten besitzen vorzugsweise die gleiche Dicke d1 der ersten amorphen Schicht des ersten Substrats und d2 der zweiten amorphen Schicht des zweiten Substrats. Das Verhältnis der Dicken d1/d2 der beiden, insbesondere gleichzeitig erzeugten, amorphen Schichten ist 0.6<d1/d2<1.4, vorzugsweise 0.7<d1/d2<1.3, noch bevorzugter 0.8<d1/d2<1.2, am bevorzugtesten 0.9<d1/d2<1.1, am allerbevorzugtesten 0.99<d1/d2<1.01.

Die Substratoberflächen beziehungsweise die erfindungsgemäß behandelten Teilbereiche der Substratoberflächen besitzen vor, während und nach der Amorphisierung eine geringe, aber insbesondere nicht vernachlässigbare, Rauheit. In einer bevorzugten Ausführungsform wird die Rauheit der Substratoberfläche beziehungsweise der erfindungsgemäß behandelten Teilbereiche der Substratoberfläche während der Amorphisierung reduziert und besitzt nach der Amorphisierung ein Minimum. Die Rauheit wird entweder als mittlere Rauheit, quadratische Rauheit oder als gemittelte Rauhtiefe angegeben. Die ermittelten Werte für die mittlere Rauheit, die quadratische Rauheit und die gemittelte Rauhtiefe unterscheiden sich im Allgemeinen für dieselbe Messstrecke beziehungsweise Messfläche, liegen aber im gleichen Größenordnungsbereich. Eine Messung der Oberflächenrauheit erfolgt mit einem der (dem Fachmann bekannten) Messgeräte, insbesondere mit einem Profilometer und/oder einem Rasterkraftmikroskop (AFM). Die Messfläche beträgt dabei insbesondere 2 µm x 2 µm. Daher sind die folgenden Zahlenwertebereiche für die Rauheit entweder als Werte für die mittlere Rauheit, die quadratische Rauheit oder für die gemittelte Rauhtiefe zu verstehen. Die Rauheit der Substratoberfläche beziehungsweise der erfindungsgemäß behandelten Teilbereiche der Substratoberfläche vor der Amorphisierung ist erfindungsgemäß insbesondere kleiner als 20 nm, vorzugsweise kleiner als 10 nm, noch bevorzugter kleiner als 8 nm, am bevorzugtesten kleiner als 4 nm, am allerbevorzugtesten kleiner als 1 nm. Die Rauheit der Substratoberfläche beziehungsweise der erfindungsgemäß behandelten Teilbereiche der Substratoberfläche nach der Amorphisierung ist insbesondere kleiner als 10 nm, vorzugsweise kleiner als 8 nm, noch bevorzugter kleiner als 6 nm, am bevorzugtesten kleiner als 4 nm, am allerbevorzugtesten kleiner als 1 nm.

Das Verhältnis zwischen der gesamten Oberfläche F des Substrats und der gereinigten und/oder amorphisierten Oberfläche f wird als Reinheitsgrad r bezeichnet. Der Reinheitsgrad ist vor dem erfindungsgemäßen Bond vorgang insbesondere größer als 0, vorzugsweise größer als 0.001, noch bevorzugter größer als 0.01, am bevorzugtesten größer als 0.1, am allerbevorzugtesten 1. Der Reinheitsgrad r entspricht insbesondere auch dem Verhältnis zwischen der Fläche der getackten Teilbereiche f' und der Fläche der gesamten Oberfläche F.

Die Reinigung und/oder die Amorphisierung finden bevorzugt in dem vorzugsweise als Vakuumkammer ausgebildeten Vorbehandlungsmodul statt. Die Vakuumkammer ist insbesondere auf weniger als 1 bar, vorzugsweise weniger als 1 mbar, noch bevorzugter weniger als 10⁻³ mbar, am bevorzugtesten weniger als 10⁻⁵ mbar, am allerbevorzugtesten weniger als 10⁻⁸ mbar evakuierbar. Die Vakuumkammer wird, insbesondere vor der Verwendung der Ionen zur Amorphisierung, vorzugsweise auf einen vorgenannten Druck, noch bevorzugter vollständig, evakuiert. Insbesondere werden der Sauerstoffanteil und insbesondere auch der Feuchtigkeits-Anteil (Wassergehalt) in der Prozesskammer so stark reduziert, dass eine erneute Oxidation der Substratoberflächen nicht möglich ist.

Der lonisierungsprozess wird insbesondere in PCT/EP2014/063303 beschrieben, auf die insoweit Bezug genommen wird. Die exakte Wahl des Einfallswinkels erlaubt die Steuerung der Abtragungsrate und damit der Oberflächenrauheit. Der Einfallswinkel wird insbesondere so gewählt, dass Amorphisierung, Abtragung der Verunreinigungen, insbesondere der Oxide, und Oberflächenglättung für das gewünschte Ergebnis maximiert werden. Unter Maximierung versteht man insbesondere eine vollständige Entfernung der Verunreinigungen, insbesondere der Oxide, eine noch weitere, insbesondere vollständige, Glättung der Oberfläche (also eine Reduktion des Rauheitswertes auf null) sowie eine optimal amorphisierte Schicht. Gase beziehungsweise Gasgemische und Parameter wie kinetische Energie der Teilchen, Einfallswinkel des Ionenstrahls, Stromdichte und Behandlungsdauer wurden in PCT/EP2014/063303 beschrieben.

### Åusrichtung/Justierung und Vorfixierung/Tacken

Nach der Vorbehandlung (Amorphisierung und/oder Reinigung) mindestens einer der beiden Substratoberflächen erfolgt insbesondere eine Ausrichtung der beiden Substrate zueinander in einem Ausrichtungsmodul. Vorzugsweise erfolgt die Ausrichtung durch Justier- beziehungsweise Ausrichtungsanlagen (engl.: aligner), insbesondere anhand von Ausrichtungsmarken auf des Substraten. Besonders kritisch ist der Moment des Ablegens/Kontaktierens der Substrate, da Ausrichtungsfehler sich addieren und/oder nicht mehr ohne weiteres korrigiert werden können. Dies führt zu erheblichem Ausschuss. Erfindungsgemäß wird somit insbesondere eine Justiergenauigkeit beziehungsweise ein Offset von weniger als 100 µm angestrebt, insbesondere weniger als 10 µm, vorzugsweise weniger als 1 µm, mit allergrößtem Vorzug kleiner als 100 nm, am bevorzugtesten weniger als 10 nm.

Das Tacken erfolgt insbesondere im gleichen Modul, also im Ausrichtungsmodul, in dem auch die Ausrichtung der jeweiligen Substrate stattfindet/stattfand. In einer alternativen Ausführungsform kann das Tacken auch in einem separaten Vorfixierungsmodul stattfinden. Das Tacken wird mittels einer Vorfixierungseinheit durchgeführt, die geeignet ist, zwei Substrate zumindest lokal miteinander zu verbinden. Vorzugsweise wird/werden die Gesamtfläche oder bevorzugt eine (oder mehrere) Teilfläche(n) mit einer vorgegebenen (geringen) Kraft und/oder einem Energieeintrag zur Vorfixierung beaufschlagt. Daraus ergibt sich dann eine für die Vorfixierung ausreichende Bondstärke. Bevorzugt wird durch die Vorfixierung nicht eine volle Bondstärke zwischen den Substraten erreicht. Die Bondstärke wird bevorzugt so eingestellt, dass die Substrate während dem Transport fixiert sind.

Gemäß einer ersten Ausführungsform wird nur eine Teilfläche eines Substrats mit dem zweiten Substrat kontaktiert. Dies wird insbesondere durch lokales Aufbringen einer Kraft, um den äquivalenten Druck für spontane Bonds in Teilflächen zur Vorfixierung der Substrate zu erreichen. Spontanes Bonden ist abhängig vom Oberflächentyp (Material, Rauigkeit, usw.) und von der Oberflächenvorbehandlung (Polieren, chemische Reinigung, usw.). Bonden wird als spontan bezeichnet, wenn sich die Bondwelle ohne äußere Einwirkung (wie z.B. Druck), also selbsttätig, ausbreitet. Somit wird die Ausrichtung mit der vorgegebenen Ausrichtungsgenauigkeit fixiert, ohne dabei die nachteiligen nötigen hohen Kontaktkräfte oder Temperatur für vollflächige Bonds zu verwenden.

In einer zweiten Ausführungsform wird vollflächig getackt und durch noch geringere Bondkraft bezogen auf die gesamte Substratfläche ein entsprechender Bond realisiert. Die Bondstärke reicht insbesondere aus, um die Substrate während des Transports zu fixieren. Es gilt dabei grundsätzlich, dass die Bondstärke eine Funktion aus Rauheit, Amorphisierungsgrad und Dicke der amorphen Schicht sowie der aufgebrachten Kraft ist.

In einer erfindungsgemäßen Ausführungsform handelt es sich bei der Vorfixierungseinheit um eine Vorrichtung, die in der Lage ist, Wärme lokal, insbesondere gepulst, an der Kontaktfläche einzubringen. Zur Erzeugung von Wärme können insbesondere elektrische Felder, magnetische Felder oder elektromagnetische Strahlung, vorzugsweise Laser, genutzt werden.

In Weiterbildung der Erfindung ist die Vorfixierungseinheit als Elektrode ausgebildet. Die Elektrode wird über die beiden miteinander zu verbindenden Substrate mit einer Gegenelektrode, insbesondere eine Platte oder Teil eines entsprechenden Probenhalters, kapazitiv gekoppelt. Die Elektrode besitzt vorzugsweise eine möglichst spitz zulaufende Elektrodenspitze, um die elektrische Feldstärke zu erhöhen. Die elektrische Feldstärke ist insbesondere größer als 0.01 V/m, vorzugsweise größer als 1 V/m, noch bevorzugter größer als 100 V/m, am bevorzugtesten größer als 10000 V/m, am allerbevorzugtesten größer als 1 MV/m. In einer ganz besonders bevorzugten Ausführußgsform werden die Elektroden durch eine Wechseispannung beansprucht. Die Frequenz der Wechselspannung ist insbesondere größer als 100000 10 Hz, vorzugsweise größer als 1000 Hz, noch bevorzugter größer als 100000 Hz, am bevorzugtesten größer als 10 MHz. Die Wechselspannung eignet sich insbesondere dann zum erfindungsgemäßen, punktförmigen Tacken, wenn die Substrate, insbesondere vorwiegend, aus dielektrischem Material bestehen, welches eine Barriere für den Stromfluss einer Gleichspannung darstellt. Durch die erfindungsgemäße Verwendung von Wechselspannung erfolgt bei zumindest teilweise vorhandenen metallischen Schichten eine Erhitzung durch den sogenannten "skin-effekt".

In einer alternativen Weiterbildung ist die Vorfixiereinheit als Anlage zur Erzeugung elektromagnetischer Strahlung, vorzugsweise als Laser, ausgebildet. Der Laser besitzt insbesondere eine Wellenlänge, die für eine optimale Erhitzung mindestens eines Materials im Substratstapel sorgt. Die Wellenlänge liegt vorzugsweise im Bereich zwischen 1 nm und 1 mm, noch bevorzugter zwischen 200 nm und 1 mm, noch bevorzugter zwischen 400 nm und 1 mm, am bevorzugtesten zwischen 600 nm und 1 mm, am allerbevorzugtesten zwischen 800 nm und 1 mm. Der Laser ist daher vorzugsweise ein Infrarotlaser. Der Durchmesser des Laserstrahls ist insbesondere kleiner als 10 mm, vorzugsweise kleiner als 5 mm, noch bevorzugter kleiner als 2 mm, am bevorzugtesten kleiner als 1 mm, am allerbevorzugtesten kleiner als 0.5 mm. Die Laserleistung ist insbesondere größer als 10 W, vorzugsweise größer als 100 W, noch bevorzugter größer als 1000 W, am bevorzugtesten größer als 0.01 MW.

In einer weiteren alternativen Ausführungsform weist die Vorfixiereinheit eine Mikrowellenquelle, insbesondere ein Amplitron, Magnetron, Stabilotron, Carznotron oder Klystron, auf. Die Mikrowellen der Mikrowellenquelle werden durch optische Elemente, insbesondere Wellenleiter, noch bevorzugter Hohlwellenleiter, auf die zu tackeden Stellen der Substrate geleitet, insbesondere fokussiert, vorzugsweise ohne Beaufschlagung der nicht zu tackenden Stellen der Substrate. Die Verwendung von Mikrowellenquellen ist besonders dann bevorzugt, wenn die Substratoberflächen mit einer Restfeuchtigkeit, insbesondere einer monoatomaren Lage Wasser, benetzt sind. Durch die gezielte, örtliche Bestrahlung mit Mikrowellen werden die Substratoberflächen mittels des Wassers stark erhitzt, so dass eine permanente Verbindung der Substratoberflächen, insbesondere Silizium- und/oder Siliziumdioxidoberflächen, durch Sauerstoffbrücken hergestellt wird. Der Durchmesser des durch Wellenleiter, insbesondere Hohlwellenleiter, fokussierten Mikrowellenstrahls ist insbesondere kleiner als 10 mm, vorzugsweise kleiner als 5 mm, noch bevorzugter kleiner als 2 mm, am bevorzugtesten kleiner als 1 mm, am allerbevorzugtesten kleiner als 0.5 mm. Die Mikrowellenquellenleistung ist vorzugsweise größer als 10 W, vorzugsweise größer als 100 W, noch bevorzugter größer als 1000 W, am bevorzugtesten größer als 0.01 MW.

In einer weiteren erfindungsgemäßen Ausführungsform wird die Vorfixiereinheit als Druckvorrichtung ausgeführt, die die Substrate mit einer oder mehreren lokalen Flächenlasten beaufschlagend ausgebildet ist. Die Flächenlast wird insbesondere durch einen Druckstempel eingebracht. Eine Druckfläche des Druckstempels auf einer von der Bondseite abgewandten Druckseite des Substrats liegt insbesondere im Bereich zwischen 0,5 mm² und 1000 mm², vorzugsweise zwischen 0,5 mm² und 500 mm², noch bevorzugter zwischen 1 mm² und 100 mm², am bevorzugtesten zwischen 4 mm² und 100 mm². Der mit dem Druckstempel übertragene/übertragbare Druck liegt insbesondere zwischen 0.1 N/cm² und 1000 N/cm², vorzugsweise zwischen 1 N/cm² und 600 N/cm², noch bevorzugter zwischen 1 N/cm² und 400 N/cm². Eine Steuerung erfolgt durch den Druck oder die Kraft, mit der die Druckstempel das Substrat beaufschlagen. Von der definierten oder vorgegebenen Bondstärke zur Vorfixierung hängt die Größe der Teilfläche zur Vorfixierung ab. Diese ist insbesondere für einen 200mm-Si-Wafer größer als 0,1 J/m², vorzugsweise größer als 0,2 J/m², noch bevorzugter größer als 0,5 J/m², am bevorzugtesten größer als 1 J/m², am aller bevorzugtesten größer als 1,5 J/m²,

Vorzugsweise weist einer der beiden Substrathalter einen Ausschnitt oder Einschnitt auf, damit der Druckstempel direkt auf das Substrat wirken kann. Der Prozess wird mit einem Druckstempel, vorzugsweise im Zentrum des Substrats, oder alternativ mit mehreren Druckstempeln durchgeführt. An den mit dem Druckstempel(n) beaufschlagten Teilflächen wird ein kovalenter Bond erzeugt, der stark genug ist, um das getackte Substratpaar in eine Bondkammer zu transferieren für eine finale ganzflächige Druckbeaufschlagung und gegebenenfalls Ausheizen des Substratpaars. Die Ausrichtungseinheit kann somit auf die verglichen mit dem Stand der Technik geringere resultierende Vorfixierungskraft ausgelegt werden. Die Kraft, die für das Erreichen der (maximalen erforderlichen) Bondstärke notwendig ist, hängt insbesondere von der Qualität der Oberfläche ab, der Dicke der amorphen Schicht, dem Amorphisierungsgrad, der OberflächenRauheit, der Sauberkeit der Oberfläche und/oder vom Material oder der Materialkombination der Substrate ab.

Werden zwei Druckstempel eingesetzt, sind diese insbesondere mit einem Winkel von 180° zueinander angeordnet. In einem weiteren Ausführungsbeispiel werden ein Druckstempel im Zentrum und ein zweiter auf einem mittleren oder äußeren Radius positioniert. Werden drei Druckstempel eingesetzt, sind diese vorzugsweise in einem gleichseitigen Dreieck angeordnet (Winkel zueinander von 120°). Werden vier Druckstempel eingesetzt, sind diese mit einem Winkel von 90° zueinander positioniert. Werden mindestens zwei Druckstempel eingesetzt, sind diese bevorzugt symmetrisch angeordnet. Werden mindestens zwei Druckstempel symmetrisch angeordnet, kann zusätzlich noch dazu im Zentrum ein Druckstempel eingesetzt werden. Vorzugsweise sind die Druckstempel gleichmäßig auf den Substraten verteilt angeordnet.

Bei Verwendung mehrerer Druckstempel können diese sequentiell einzeln oder in Gruppen mit Kraft beaufschlagt werden, um die Belastung für die Substrathalter zu minimieren.

In einer erfindungsgemäßen Ausführungsform weist das Vorfixierungsmodul genau eine Vorfixierungseinheit auf, die geeignet ist, einen, insbesondere mechanischen, Druck auf die Oberfläche des Substratstapels, insbesondere auf die Oberfläche des Produktsubstrats, auszuüben. Die Vorfixierungseinheit kann erfindungsgemäß eine Punktbeaufschlagungseinheit sein. Die Punktbeaufschlagungseinheit ist mit Vorzug stiftförmig ausgeprägt. Die Spitze des Stiftes kann unterschiedliche Formen aufweisen. So sind spitz zulaufende Formen, abgerundete, insbesondere kugelförmige, oder rechteckige Formen denkbar. Das Tacken nutzt lokales Aufbringen von Kraft, um den äquivalenten Druck für spontane Bonds in Teilflächen zu erreichen und dadurch die Substrate vorzufixieren beziehungsweise zu tacken.

In Weiterbildung der Erfindung ist die Vorfixierungseinheit zusätzlich heizbar. Die Temperatur der Vorfixierungseinheit kann insbesondere mit einer Genauigkeit besser als 5°C, vorzugsweise besser als 2°C, noch bevorzugter besser als 1°C, am bevorzugtesten besser als 0.1°C, am allerbevorzugtesten besser als 0.01°C reguliert werden. Der ansteuerbare Temperaturbereich der Vorfixierungseinheit liegt insbesondere zwischen Raumtemperatur und 700°C, vorzugsweise zwischen Raumtemperatur und 300°C, noch bevorzugter zwischen Raumtemperatur und 120°C, am bevorzugtesten zwischen 18°C und 30°C, am allerbevorzugtesten bei Raumtemperatur. Die Einbringung von Wärme führt vor allem zu einer (lokal begrenzten) Erwärmung.

In einer weiteren erfindungsgemäßen Ausführungsform weist die Punktbeaufschlagungseinheit einen, insbesondere möglichst exakt fokussierbaren, Laser auf. Das kohärente Laserlicht wird durch Optiken vorzugsweise in einem Fokus gebündelt, der sich zwischen dem Produktsubstrat und dem Trägersubstrat, also in der Verbindungsschicht, befindet. Dadurch wird eine örtlich möglichst begrenzte, intensive und schnelle Erwärmung der Verbindungsschicht bewirkt. Bevorzugt wird der Laser gepulst, insbesondere durch kontinuierliches, vorzugsweise hochfrequentes, Ein- und Ausschalten. Durch ein derartiges Pulsen wird die Erwärmung der Umgebung weitestgehend bis ganz vermieden. Der Laser ist insbesondere ein Infrarotlaser, ein Laser für sichtbares Licht oder ein Laser für UV Licht.

In einer besonders bevorzugten Ausführungsform vereint die Vorfixierungseinheit eine Heiz- und/oder Druck- und/oder Lasereinheit, sodass gleichzeitig thermische und/oder mechanische und/oder photochemische Beanspruchungen möglich sind. Die Vorfixierungseinheit ist gemäß einer bevorzugten Ausführungsform der Erfindung in jeder Ausführungsform mindestens entlang der z-Achse bewegbar.

Gemäß einer weiteren erfindungsgemäßen Ausführungsform ist es denkbar, vollflächig zu Tacken und durch geringere, jedoch auf die gesamte Substratfläche bezogene Kraft einen entsprechenden Bond zu realisieren. Bei dieser Ausführungsform handelt es sich bei der Vorfixierungseinheit vorzugsweise um eine Druckvorrichtung, die eine Flächenlast vollflächig mit einer Druckplatte einbringen kann. Der hergestellte Vorbond zeichnet sich insbesondere durch eine Bindungsfestigkeit zwischen 0.01 J/m² und 5 J/m², mit Vorzug größer als 0.1 J/m², bevorzugter größer als 0.2 J/m², noch bevorzugter größer als 0.5 J/m², am bevorzugtesten größer als 1 J/m², mit allergrößtem Vorzug größer als 1.5 J/m² aus.

Die Erfindung wird bevorzugt bei polierten Substratoberflächen angewendet, die eine Vorbehandlung für kovalente Bonds erlauben. Das sind typischerweise Substratoberflächen mit einem Mittenrauwert Ra kleiner als 20 nm, bevorzugter mit einem Ra kleiner als 10 nm, noch bevorzugter mit einem Ra kleiner als 2 nm, am bevorzugtesten mit einem Ra kleiner als 1 nm gemessen auf einem 2x2 µm² Feld mit AFM. Der Mittenrauwert beziehungsweise arithmetischer Mittenrauwert Ra beschreibt die Rauheit einer technischen Oberfläche. Zur Ermittlung dieses Messwertes wird die Oberfläche auf einer definierten Messstrecke abgetastet und sämtliche Höhen- und Tiefenunterschiede der rauen Oberfläche aufgezeichnet. Nach der Berechnung des bestimmten Integrals dieses Rauheitsverlaufes auf der Messstrecke wird abschließend dieses Ergebnis durch die Länge der Messstrecke dividiert.

Der lokale Krafteintrag erfolgt insbesondere derart, dass die Mikrorauheit der Substratoberflächen überwunden wird und ein möglichst hoher Anteil an Oberflächenmolekülen der gegenüberliegenden Substrate Bindungsenergien aufbaut. Insbesondere polierte Substratoberflächen aus Metallen wie Aluminium, Kupfer, Oxide, Halbleitermaterialien und Glas sind für eine Vorfixierung durch lokalen Krafteintrag geeignet. Für manche Bondarten wie insbesondere Glass-Frit-Bonden oder eutektisches Bonden oder bei unpolierten Metallflächen oder Lötverbindungen wird die Oberflächengüte nicht ausreichen, um mit den offenbarten Kraftbereichen eine spontane teilflächige Verbindung zu erzeugen. In diesen Fällen erfolgt bevorzugt zusätzlich eine mechanische Klemmung des Substratstapels nach der Ausrichtung und Kontaktierung. Das wird insbesondere durch eine Klemmung gemäß PCT/EP2013/056620 realisiert.

Als, insbesondere eigenständiger Aspekt der Erfindung ist es denkbar, keine polierter, Substratoberflächen zu verwenden und/oder die Vorbehandlung entfallen zu lassen, insbesondere wenn die Substrate mit spontan bondenden Strukturen ausgestattet sind. Dies ist insbesondere der Fall wenn die Substrate Oberflächenstrukturen ähnlich eines Klettverschlusses aufweisen. Durch Berührung entsteht elastische oder auch plastische Deformation der Oberflächenstrukturen und es kommt zu einer formschlüssigen Verbindung der Substratoberflächen auf mikroskopischer Ebene. Im nachfolgenden Bondschritt kann die Vorfixierung auf die Gesamtfläche erweitert und gefestigt werden unter Verwendung von hoher vollflächiger Kraft und Temperatur.

### Bonden

Das Bonden erfolgt insbesondere in einer separaten Bondkammer, wobei die Bondkammer vorzugsweise in einer Cluster-Anlage integral an die Prozesskammer zur Vorbehandlung, insbesondere Amorphisierung angeschlossen ist, noch bevorzugter unter ständiger Aufrechterhaltung der Evakuierung von der Prozesskammer in die Bondkammer überführbar ist.

In einem weiteren erfindungsgemäßen Schritt erfolgt der Bondvorgang des vorfixierten/getackten Substratstapels zur Ausbildung eines permanenten Bonds. Der Bondvorgang besteht insbesondere aus einer Kraft und/oder Temperatureinwirkung. Die erfindungsmäße Bondtemperatur ist insbesondere kleiner als 1100°C, vorzugsweise kleiner als 400°C, noch bevorzugter kleiner als 200 °C, am bevorzugtesten zwischen 18°C und 200°C, am allerbevorzugtesten bei Raumtemperatur. Dabei liegt die Bondkraft insbesondere zwischen 0.5 und 500 kN, mit Vorzug zwischen 0.5 und 250 kN, mit größerem Vorzug zwischen 0,5 und 200 kN, am bevorzugtesten zwischen 1 und 100 kN. Die entsprechenden Druckbereiche ergeben sich durch Normierung der erfindungsgemäßen Bondkraft auf die Fläche der Substrate. Die angestrebte Bondstärke für den vollflächigen Bond ist mit Vorzug größer als 1 J/m², bevorzugt größer als 1.5 J/m², mit größerem Vorzug größer als 2 J/m². Die Substrate können eine beliebige Form besitzen. Insbesondere sind die Substrate kreisförmig und werden gemäß Industriestandard über den Durchmesser charakterisiert. Für Substrate, insbesondere die sogenannten Wafer, gelten vorzugsweise die industrieüblichen Durchmesser, 1 Zoll, 2 Zoll, 3 Zoll, 4 Zoll, 5 Zoll, 6 Zoll, 8 Zoll, 12 Zoll und 18 Zoll. Mit dem erfindungsgemäßen Verfahren kann aber grundsätzlich jedes Substrat, insbesondere Halbleitersubstrat, unabhängig von dessen Durchmesser verarbeitet werden.

Erfindungsgemäß führt die Druckbeanspruchung zu einer weiteren Annäherung der Substratoberflächen an der (entlang der Kontaktfläche der Substratoberflächen ausgebildeten) Grenzschicht, soweit durch den Vorbond noch keine Kontaktierung erfolgt. Die immer weitere Annäherung der Substratoberflächen führt zu einer kontinuierlichen Verkleinerung und einem letztendlichen Verschluss von Kavitäten. Erfindungsgemäß spielt dabei die Amorphisierung eine entscheidende Rolle, da durch den amorphen Zustand eine oberflächenisotrope elektrostatische Anziehung erfolgt. Da die miteinander kontaktierenden, amorphen Schichten der Substratoberflächen beide nicht kristallin sind, muss auch nicht auf eine das Kristallgitter fortsetzende und angepasste Kontaktierung geachtet werden. Die Kontaktierung zweier Substratoberflächen mit amorphen Schichten führt damit zur Erzeugung einer neuen, größeren, amorphen Schicht. Der Übergang gestaltet sich fließend und ist erfindungsgemäß insbesondere durch das vollständige Verschwinden einer Grenzschicht charakterisiert.

Die Dicke der gesamten, fertig gebondeten amorphen Schicht des Substratstapels, insbesondere unmittelbar nach dem Bondvorgang, ist insbesondere kleiner als 100 nm, vorzugsweise kleiner als 50 nm, noch bevorzugter kleiner als 10 nm, am bevorzugtesten kleiner als 5 nm, am allerbevorzugtesten kleiner als 2 nm. Die Bondstärke wird insbesondere durch folgende Parameter beeinflusst, nämlich
- die Dicke der amorphen Schicht,
- die Rauheit,
- die Anzahl von sich negativ auswirkenden, in der Grenzschicht vorhandenen Ionen und
- die Bondkraft.

Die Bondstärke nimmt mit steigender Dicke der amorphen Schicht insbesondere zu. Je dicker die amorphe Schicht, desto größer die Anzahl der regellos angeordneten Atome. Die regelloss angeordneten Atome unterliegen keinem Fern- und/oder Nahordnungsparameter und werden durch genannte Prozesse, insbesondere Diffusion und/oder Annäherung durch Druckbeaufschlagung, Kavitäten an der Grenzschicht füllen. Hierdurch wird die Kontaktfläche und damit die Bondstärke erhöht. Bevorzugt ist die mittlere Dicke der amorphen Schicht größer als die mittlere Rauheit, damit genügend Atome der amorphen Phase zur Verfügung stehen, um die Kavitäten zu schließen. Vorzugsweise wird eine Substratoberfläche mit einer sehr geringen Rauheit gewählt, damit diese über möglichst kleine Kavitäten verfügt. Je geringer also die Rauheit einer Substratoberfläche, desto geringer kann auch die Dicke der amorphen Schicht sein, um ein gewünschtes Bondergebnis zu erhalten. Eine entsprechend dicke amorphe Schicht wird erfindungsgemäß durch eine entsprechend hohe Ionenenergie erreicht, welche dazu führt, dass die Ionen möglichst tief in das Substrat eindringen können.

Die Bondstärke ist auch eine Funktion der Reinheit der amorphen Schicht. Jedes eingelagerte unerwünschte Atom oder Ion kann insbesondere zur Destabilisierung, insbesondere Erniedrigung der Bondfestigkeit führen. Die der Amorphisierung dienenden Ionen können daher auch einen negativen Einfluss auf die Bondstärke haben, insbesondere wenn sie nach der Amorphisierung in der amorphen Schicht verbleiben. Daher wird neben einer entsprechend geringen Ionenenergie auch eine möglichst geringe Stromdichte und Behandlungsdauer angestrebt. Multipliziert man die Stromstärke mit der Behandlungsdauer, erhält man die pro Einheitsflächenabschnitt innerhalb der Behandlungsdauer auf der Substratoberfläche aufgetroffenen Ionen. Um diese Anzahl zu minimieren, können die Stromdichte und/oder die Behandlungszeit reduziert werden. Je weniger Ionen pro Einheitsfläche auf der Substratoberfläche auftreffen, desto weniger Ionen werden in die amorphe Schicht implantiert. Negative Auswirkungen auf die Bondstärke haben vor allem jene Teilchen, welche mit dem zu morphisierenden Material keine Bindung eingehen können und nur als Defekte, insbesondere Punktdefekt, vorliegen. Dazu zählen, vor allem die Edelgase, aber auch molekulare Gase. Insbesondere ist erfindungsgemäß die Verwendung von Gasen beziehungsweise Gasgemischen denkbar, deren Ionen für eine Verstärkung des Bondinterfaces, insbesondere durch Bildung neuer Phasen, verantwortlich sind. Eine bevorzugte Möglichkeit ist die Verwendung von ionisiertem Stickstoff, der die amorphe Schicht nitriert.

Analoge Überlegungen gelten für alle anderen Arten von Elementen, welche eine Verbindung, insbesondere eine metallische, kovalente oder ionische Bindung mit dem Material der amorphen Schicht eingehen. Um die Stromdichte erniedrigen zu können, werden insbesondere Substratoberflächen bevorzugt, die bereits über eine minimale Rauheit verfügen. Je glatter die Substratoberfläche, desto weniger und niederenergetischere Ionen werden erfindungsgemäß für die Reduktion der Rauheit benötigt. Dadurch wird eine Reduktion der Ionenenergie und/oder des lonenstroms und damit der Anzahl der Ionen pro Einheitsfläche ermöglicht, was wiederum zu einer geringeren Anzahl eingebauter Ionen und in der Folge zu weniger Defekten und schließlich zu einer erhöhten Bondfestigkeit führt.

Die Bondstärke ist eine Funktion der Bondkraft, da eine höhere Bondkraft zu einer stärkeren Annäherung der Substratoberflächen und damit zu einer besseren Kontaktfläche führt. Je höher die Bondkraft, desto leichter werden Substratoberflächen aneinander angenähert und verschließen damit durch lokal verformte Bereiche die Kavitäten.

Eine, insbesondere von dem Amorphisierungsprozess getrennte, Wärmebehandlung erfolgt insbesondere entweder während und/oder nach dem Bonden in dem Bonder oder nach dem Bonden in einem externen (insbesondere in den Cluster integrierten) Wärmebehandlungsmodul. Bei dem Wärmebehandiungsmodul kann es sich um eine Heizplatte, einen Heizturm, einen Ofen, insbesondere einen Durchlaufofen oder jede andere Art von wärmeerzeugender Vorrichtung handeln. Die Wärmebehandlung findet insbesondere bei Temperaturen kleiner 500°C, vorzugsweise kleiner 400°C, noch bevorzugter kleiner 3000°C, am bevorzugtesten kleiner 200°C, am alierbevorzugtesten kleiner 100°C statt, jedoch über Raumtemperatur. Die Zeitdauer der Wärmebehandlung wird insbesondere derart gewählt, dass die Dicke der erfindungsgemäßen, amorphen Restschicht nach der Wärmebehandlung kleiner als 50 nm, vorzugsweise kleiner als 25 nm, noch bevorzugter kleiner als 15 nm, am bevorzugtesten kleiner als 10 nm, am allerbevorzugtesten kleiner als 5 nm, ist.

Insbesondere erfolgt beim und/oder nach dem Bonden und/oder bei der Wärmebehandlung eine Phasenumwandlung vom amorphen Zustand in den kristallinen Zustand. In einer ganz bevorzugten erfindungsgemäßen Ausführungsform werden die genannten Prozessparameter so gewählt, dass eine vollständige Umwandlung der amorphen Schicht in die kristalline Phase erfolgt.

Gemäß einer vorteilhaften Ausführungsform wird ein Material mit einer Reinheit des umwandelnden Materials in Massenprozent (m%) insbesondere größer als 95m%, vorzugsweise größer als 99m%, noch bevorzugter größer als 99.9m%, am bevorzugtesten größer als 99.99m%, am alierbevorzugtesten größer als 99.999m%, gewählt. Durch eine große Reinheit des Substratmaterials wird ein noch besseres Bondergebnis erzielt.

Zuletzt werden die gebondeten Substrate aus dem Hochvakuum ausgeschleust. Dies kann beispielsweise über einem Schleusentor, insbesondere eine "Gate Valve", erfolgen.

Mit dem erfindungsgemäßen Verfahren und Vorrichtung können sehr hohe Bondstärken (>2 J/m²) bei Raumtemperatur erreicht werden. Es können dabei Vorrichtungen mit oder ohne Präzisionsjustierung (ohne Justiereinheit) eingesetzt werden. Das Vorbehandlungsmodul erzeugt vorzugsweise eine amorphisierte Oberfläche der Substrate (beispielsweise Halbleitermaterial, Oxide oder polierte Metalle wie Al, Cu, Glas, Keramiken). Die Substrate werden insbesondere aktiviert und ein hoher Anteil an Mikrokontaktflächenberührungen bei Kontakt zweier Substrate wird ermöglicht. Es können sich dadurch spontane, kovalente Bonds bei geringen Temperaturen, auch bei Raumtemperatur, ausbilden. Diese spontanen Bonds werden durch Kontaktierung im Hochvakuum begünstigt, bevorzugt im Ultrahochvakuum (<1E⁻⁶, besser <1E⁻⁷ mbar).

Weitere Vorteile, Merkmale und Einzelheiten der Erfindung ergeben sich aus der nachfolgenden Beschreibung bevorzugter Ausführungsbeispiele sowie anhand der Zeichnungen. Diese zeigen in:
- Figur 1: eine schematische Darstellung einer zur Durchführung eines erfindungsgemäßen Verfahrens geeignete Ausführungsform der erfindungsgemäßen Vorrichtung in einer Ansicht von oben,
- Figur 2: eine seitliche Teilansicht der Ausführungsform aus Figur 1 mit einem Ausrichtungsmodul F und einer Bondstation G mit jeweils eine Transferkammer B dazwischen,
- Figur 3a: eine Aufsicht auf ein erstes Substrat eines Substratstapels in einem schematisch angedeuteten vorfixierten Zustand,
- Figur 3b: eine Aufsicht auf das erste Substrat aus Figur 3a in einem gebondeten Zustand,
- Figur 4: eine seitliche Ansicht eines Substratstapels mit einem Vergrößerungsausschnitt,
- Figur 5a: eine Aufsicht auf einen Substratstapel mit einem schraffierten Vorfixierungsbereich und
- Figur 5b: eine Aufsicht auf einen gebondeten Substratstapel.

In den Figuren sind gleiche oder gleichwirkende Merkmale mit den gleichen Bezugszeichen gekennzeichnet.

Die Erfindung wird nachstehend anhand eines Ausführungsbeispiels näher erläutert. Die darin beschriebenen Merkmale können sowohl einzeln als auch in beliebigen Kombinationen verwendet werden.

Der gezeigten Ausführungsform liegt insbesondere der Gedanke zugrunde, Substrate 1, 2 koordiniert und gleichzeitig quasi-selbsttätig an ausgewählten Stellen zu kontaktieren und so miteinander als Substratstapel 3 zu fixieren, indem zumindest eines der zwei, bevorzugt das obere Substrat 1, mit einem Druckstempel 6 bevorzugt konzentrisch zu einer Mitte M des Substratstapels beaufschlagt wird und durch diese Kontaktierung, insbesondere in der Mitte M des oberen ersten Substrats 1, die Substrate vorfixiert werden.

In einer erfindungsgemäßen Anlage werden insbesondere die Prozessschritte Vorjustierung, Vorbehandlung (Oxid-Entfernung und/oder Amorphisierung), Ausrichtung und Vorfixierung, Bonden, und gegebenenfalls eine Inspektion (Metrologie) integriert. Die Anlage verfügt insbesondere über mindestens eine Modulgruppe mit einem gemeinsamen, gegenüber der Umgebungsatmosphäre abschließbaren Arbeitsraum 20, der insbesondere für eine Hochvakuumatmosphäre k ausgelegt ist. Insbesondere können die Module, insbesondere ein Vorbehandlungsmodul D, ein Ausrichtungsmodul F und ein Bondmodul G, linearförmig angeordnet werden mit jeweils einer Transferkammer B mit Bewegungseinrichtung (Robotersystem) dazwischen.

Alternativ können gemäß einer bevorzugten Ausführungsform die Module clusterförmig oder sternförmig um ein Zentralmodul mit einer Bewegungseinrichtung (Robotersystem) angeordnet werden. Besonders vorteilhaft ist die sternförmige Variante, wenn um ein Zentralmodul weiter erfindungsgemäße Module angeordnet sind, wobei diese insbesondere an dem Zentralmodul andockbar sind. Bei der Bewegungseinrichtung handelt es sich mit Vorzug um einen, insbesondere mit einem End-Effektor ausgestatteten, Industrieroboter.

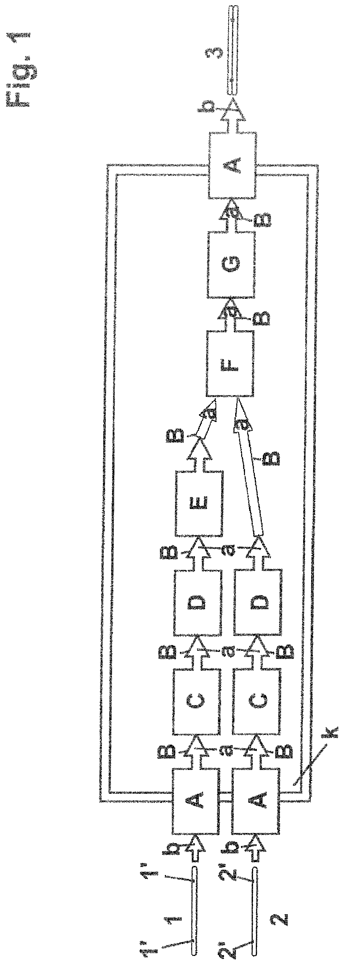

Figur 1 zeigt eine zur Durchführung des erfindungsgemäßen Verfahrens geeignete Vorrichtung mit den einzelnen Modulen beziehungsweise Stationen im Arbeitsraum 20 in einer Ansicht von oben. Eine Schleuse A dient zur Einbringung der Substrate 1, 2 von einem Umgebungsdruck außerhalb des Arbeitsraums 20 in die Hochvakuumatmosphäre k des Arbeitsraums 20. Am anderen Ende des Arbeitsraums 20 dient eine Schleuse A zum Ausschleusen der in den Modulen bearbeiteten Substrate 1, 2, insbesondere als gebondeter Substratstapel 3.

Das Ein- und Ausschleusen wird in Figur 1 durch einen Pfeil b dargestellt. Die Schleuse A gewährleistet dabei, dass der Vakuumwert der Hochvakuumkammer (beispielsweise der Transferkammer B) nicht oder nur minimal beeinträchtigt wird durch Einbringen neuer Substrate 1, 2 oder Ausbringen des gebondeten Substratstapels 3. Vorzugsweise besteht die Schleuse A aus einer Schleusenkammer, welche zur Einbringung der Substrate in die Kammer durch mindestens ein Ventil mit der Umgebung verbunden ist. Mit mindestens einem zweiten Ventil ist die Schleusenkammer mit der Hochvakuumumgebung verbunden. Die Zuführung der Substrate 1, 2 ins Hochvakuum erfolgt insbesondere über jeweils eine der Transferkammern B. Die Schleuse A ist insbesondere mit einem Pumpsystem ausgestattet, welches die Schleusenkammer nach Schließen des Ventils vom Umgebungsdruck (ca. 1013 mbar) auf einen Druck ähnlich der Transferkammer B absenken kann.

Dieser Druck ist insbesondere kleiner als 1E⁻⁴mbar, bevorzugt kleiner als 1E⁻⁵mbar, noch bevorzugter kleiner als 1E⁻⁶mbar, am bevorzugtesten kleiner als 1E⁻⁷mbar. Nach Erreichen des Zieldrucks in der Schleusenkammer kann das Ventil zur Transferkammer B hin geöffnet werden und die Substrate 1, 2 über einen, insbesondere in der Transferkammer B verbauten Roboterarm aus der Schleuse A in eine Zielkammer, insbesondereeine Vorjustiereinrichtung C, transferiert werden.

Als Pumpsysteme zum Erreichen eines derartigen Vakuums sind insbesondere Verdrängungspumpen geeignet, vorzugsweise trockenlaufende Scroll-, Kolben- oder Membranpumpen. Turbomolekularpumpen sind für den Bereich unter 1 mbar bis unter 1E⁻⁶ mbar bevorzugt und sogenannte "Cryo-Pumpen" für sehr hohes Vakuum bis unter 1E⁻⁸mbar.

Die Substrate 1, 2 werden über einen Roboterarm 9, insbesondere ohne das Vakuumniveau wesentlich zu verändern, von einer Prozessstation/Prozessmodul zur anderen transportiert, bevorzugt über eine oder mehrere Transferkammern B. Dieser Vorgang wird in Figur 1 durch Pfeile a dargestellt. In der/den Transferkammer(n) B wird mit Vorzug ein Vakuum kleiner als 1E⁻⁵ mbar, bevorzugter kleiner als 1E⁻⁶ mbar, noch bevorzugter kleiner als 1E⁻⁷ mbar, am bevorzugtesten kleiner als 1E⁻⁸ mbar während des gesamten Transfers aufrecht erhalten. Die Transferkammer B kann über Ventile 14 von den Prozessmodulen isoliert werden und verfügt über einen Roboterarm 9 mit Greifer (nicht dargestellt) für die Substrate 1, 2 beziehungsweise den Substratstapel 3.

Die Substrate 1, 2 werden zunächst in einer Vorjustiereinrichtung C vorjustiert. Im bevorzugten Ausführungsbeispiel aus Figur 1 ist für jedes der zwei Substrate 1, 2 eine Vorjustiereinrichtung C vorhanden. Die Substrate 1, 2 werden insbesondere mit nicht genau bekannter Orientierung in die Hochvakuumumgebung eingebracht. Eine typische Lagetoleranz von Substraten 1, 2 in der Schleuse A ist im Bereich von wenigen Millimeter bis wenigen hundert Mikrometer. Insbesondere die Verdrehung der Substrate 1, 2 um die Z-Achse (Hochachse) kann +/-180° vom Sollwert betragen. Die Verdrehung beziehungsweise Winkellage wird an Hand des Umfangs der Substrate festgestells, insbesondere Kanten bei quadratischen Substraten oder flats beziehungsweise notches bei Wafern. Die Vorjustiereinrichtung C nutzt diese Umfangsgeometriemerkmale, um das Substrat 1, 2 auf eine Lagegenauigkeit von +/-100 µm entlang der X- und Y Achse, sowie +/-0,1° um die Z Achse (Hochachse) grob vorzujustieren.

Nach dem Vorjustieren werder, die Substrate 1, 2 durch eine Transferkammer B in die Vorbehandlungsstation D weiter transportiert. Für die Vorbehandlungsstation D wird auf die PCT/EP2014/063303 verwiesen. Die Vorbehandlungsstation D ist ein Modul zur Plasmavorbehandlung der Substratoberflächen. Die Vorbehandlung implantiert Teilchen unter die Substratoberflächen 1o, 2o der Substrate 1, 2. Insbesondere wird bei der Plasmavorbehandlung die Si aufweisende Substratoberfläche 1o in einem Dickenbereich von 1 bis 20 nm durch Plasmabehandlung amorphisiert. An der Oberfläche verbleiben sehr reaktive Moleküle, die schnell neue Bindungen mit Molekülen des Bondpartners (zweites Substrat 2) eingehen. Die Amorphisierung reduziert die erforderliche Energie (Kraft), um Mikrokavitäten zu schließen. Es kann eine maximale Anzahl von Molekülen Kontakt finden, wobei hohe Kontaktflächenanteile und hieraus hohe Bondstärken entstehen. Daneben bewirkt die Vorbehandlung die Entfernung organischer Kontamination sowie von Oxiden von Metall- oder Halbleitermaterialien. Das ist ein gewünschter Effekt, um später eine leitfähige Oberfläche herzustellen.

Nachdem die Substrate 1, 2 in jeweils einem Vorbehandlungsmodul D vorbehandelt worden sind, werden sie zu einem Ausrichtungsmodul mit integriertem Vorfixierungsmodul F transferiert. Auf dem Weg dorthin wird eines der beiden Substrate 1, 2 in einer Wendestation E gewendet, da die Substrate 1, 2 bevorzugt mit der zu bondenden Seite (Substratoberflächen 1o, 2o) nach oben in die Module geladen. Die Prozess-Stationen, insbesondere das Vorbehandlungsmdoul D, sind bevorzugt zur Behandlung der zu bondenden Substratoberflächen 1o, 2o von oben ausgelegt.

Für das Ausrichtungsmodul F wird bevorzugt das obere Substrat 1 mit der zu bondenden Substratoberfläche 1o nach unten ausgerichtet. Die Wendestation E dreht das Substrat 1 um 180° und bereitet es damit vor für die Beladung des Ausrichtungsmoduls F. Der Transfer erfolgt bevorzugt über eine der Transferkammern B.

Das Ausrichtungsmodul F wird in der Ausführungsform gemäß Figur 1 als Modul in einer Anlage mit linear angeordneten Prozess-Modulen gezeigt. Das Ausrichtungsmodul F ist mit einer Vorfixierungseinrichtung zum Tacken ausgestattet. Das Tacken erfolgt somit im gleichen Modul. In einer alternativen Ausführungsform kann das Tacken auch in einem separaten Modul stattfinden.

Das Vorfixierungsmodul weist vorzugsweise eine Beaufschlagungseinrichtung, insbesondere einen Druckstempel 6, vorzugsweise einen im Zentrum angeordneten Druckstift, auf. Nach der Ausrichtung werden die Substrate 1, 2 kontaktiert und durch Einbringen von einer lokalen, zentrisch angeordneten Flächenlast durch den Druckstempel 6 bondet zumindest diese kleine Teilfläche spontan und fixiert die exakte Ausrichtung der Substrate 1, 2, damit diese bis zum Bonden in dem Bondmodul G nicht mehr verrutschen.

In einer alternativen Ausführungsform werden mehrere lokale Flächenlasten, beispielsweise durch mehrere Druckstempel 6, eingebracht. Dadurch bonden mehrere lokale Teilflächen spontan und fixieren die Ausrichtung an mehreren Stellen und somit besser oder mit geringerem Kraftaufwand pro Stelle.

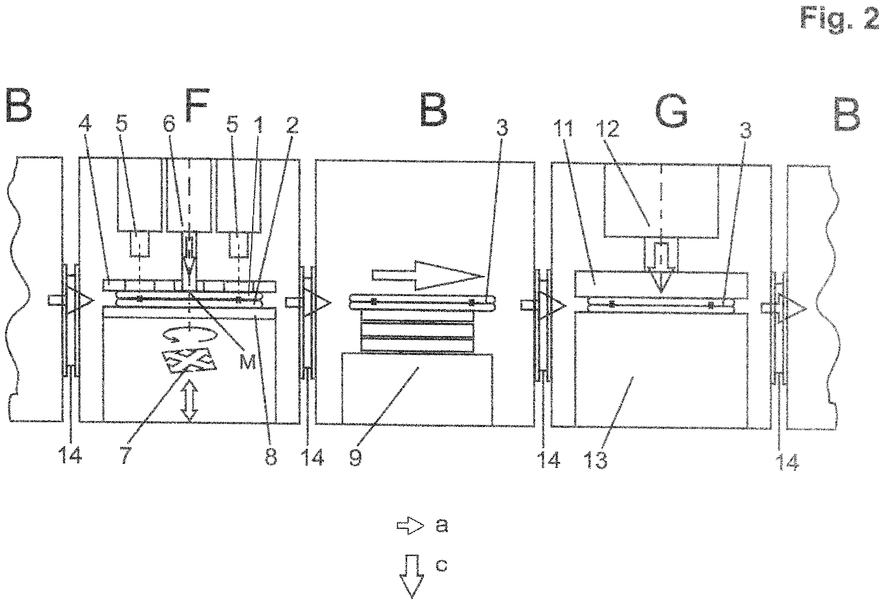

Das Ausrichtungsmodul F gemäß Figur 2 beinhaltet bevorzugt zwei Öffnungen mit Ventil 14 zur Beladung der Substrate 1, 2 und Entladung des ausgerichteten und gehefteten Substratstapels 3. Alternativ beinhaltet das Ausrichtungsmodul F nur eine Öffnung mit Ventil 14 zum Beladen und Entladen. Figur 2 zeigt im Ausrichtungsmodul F eine obere Substrataufnahmeeinrichtung 4 zur Aufnahme des oberen Substrats 1 auf einem Aufnahmekörper (nicht dargestellt). Bei Aufnahme des Substrats 1 auf die Substrataufnahmeeinrichtung 4 tritt nur eine Aufnahmefläche in Kontakt mit einer Aufnahmeseite des Substrats 1. Gegenüberliegend zur Aufnahmeseite ist die vorbehandelte, insbesondere amorphisierte, Substratoberfläche 1o des Substrats 1 angeordnet. Die Aufnahmefläche der Aufnahmeeinrichtung 4 ist insbesondere weitgehend an die Abmessungen und Umfangskontouren der verwendeten Substrate 1 angepasst.

Figur 2 zeigt im Ausrichtungsmodul F eine untere Substrataufnahmeeinrichtung 8 zur Aufnahme des unteren Substrats 2 auf einem Aufnahmekörper (nicht dargestellt). Bei Aufnahme des Substrats 2 auf die Substrataufnahmeeinrichtung 8 tritt nur die Aufnahmefläche in Kontakt mit der Aufnahmeseite des Substrats 2. Gegenüberliegend zur Aufnahmeseite ist die vorbehandelte, insbesondere amorphisierte, Substratoberfläche 2o des Substrats 2 angeordnet. Die Aufnahmefläche der Substrataufnahmeeinrichtung 8 ist insbesondere weitgehend an die Abmessungen und Umfangskontouren der verwendeten Substrate 2 angepasst.

Die untere Substrataufnahmeeinrichtung 8 ist auf einer Ausrichtungseinheit 7 angeordnet, mit der das untere Substrat 2 gegenüber dem oberen Substrat 1 in X-, Y - und Rotationsrichtung sowie in der Winkellage (Keilfehlerausgleich) ausgerichtet werden kann.

Das obere Substrat 1 ist mit Referenzmarken 1' ausgestattet. Es kann insbesondere als Produktsubstrat ausgebildet sein mit Strukturen, die Teil eines mikroelektronischen, optischen, mikromechanischen oder mikrofluidischen Bauteils sind. Das untere Substrat 2 ist auch mit Referenzmarken 2' ausgestattet. Es kann insbesondere als Produktsubstrat ausgebildet sein mit Strukturen, die Teil eines mikroelektronischen, optischen, mikromechanischen oder mikrofiuidischen Bauteils sind.

Bevorzugte Ausführungsformen zur Fixierung der Substrate 1, 2 beziehungsweise Wafer am jeweiligen Probenhalter sind eine elektrostatische Fixierung von Wafer im Hochvakuum, oder eine mechanische Fixierung durch Klemmen. Insbesondere sind die Substrataufnahmeeinrichtungen 4, 8 beziehungsweise das Ausrichtungsmodul F mittels der Ausrichtungseinheit 7 in der Lage, die beiden Substrate 1, 2 planparallel und in kleinem Abstand durch Kippen um die X- und Y-Achse für einen Keilfehlerausgleich auszurichten. Dies erfolgt vor der Ausrichtung entlang der X-Y-Rotationsachse beziehungsweise vor der Kontaktierung entlang der Z-Achse. Alternativ kann der Keilfehlerausgleich auch durch Aktuatoren in der Ausrichtungseinheit 7 stattfinden. Allgemein verfügt die Anlage vorzugsweise über ein System für einen kontaktlosen Keilfehlerausgleich zwischen den parallel ausgerichteten Substraten, wobei insbesondere auf die Offenbarung in der WO2012/028166A1 verwiesen wird.

Weiterhin hat die Substrataufnahmeeinrichtung 4 insbesondere eine Bohrung beziehungsweise einen Ausschnitt oder Einschnitt für den Druckstempel 6, um das Substrat 1 mit dem Druckstempel 6 lokal zu beaufschlagen.

Bevorzugt wird mit dem Druckstempel 6 das Substratzentrum (Mitte M) beaufschlagt, damit mechanische Spannungen durch unterschiedlichen Temperatureintrag in das obere Substrat 1 und untere Substrat 2 aufgrund der thermischen Dehnung der Materialien weitgehend vermieden werden. Alternativ dazu sind aber mehrere Druckstempel vorstellbar, insbesondere bei einem reinen Raumtemperaturprozess oder bei der Verarbeitung von Materialien mit nicht vorhandener oder sehr geringer thermischer Dehnung.

In einer alternativen Ausführungsform kann der obere Substrathalter 4 flexibel ausgeführt werden um die Flächenlast des Druckstempels 6 lokal an das Substratpaar zu übertragen.

Bei der Ausführungsform gemäß Figur 2 ist genau ein Druckstempel 6 vorgesehen. Mit diesem wird mechanischer Druck auf die Oberfläche des Substratstapels 3, insbesondere auf die Aufnahmeseite des Substrats 1, ausgeübt.

Der Druckstempel 6 ist bevorzugt als Aktuator mit der Fähigkeit ausgeführt, kontrolliert mit der Aufnahmeseite des oberen Substrats 1 in Kontakt zu fahren und einen definierten Krafteintrag einzustellen. Vorzugsweise wird diese Kraft über eine Steuerung, insbesondere Druck oder Strom, kontrolliert. Noch bevorzugter wird die Kraft über eine Wägezelle geregelt, um eine exakt reproduzierbare und kalibriert gemessene Kontaktkraft einzuleiten.

Der Druckstempel 6 ist mit Vorzug stiftförmig ausgeprägt. Die Spitze des Stiftes kann unterschiedliche Formen aufweisen. So sind spitz zulaufende Formen, abgerundete, insbesondere kugelförmige, oder rechteckige Formen denkbar. Die Kontaktfläche des Druckstempels kann bombiert oder eben ausgeführt werden.

Bei dieser erfindungsgemäßen Ausführungsform wird das Vorfixieren mit einem Aktuator im Substratzentrum durchgeführt. Dabei wirkt die resultierende Kraft Fa durch die Ansteuerung des Aktuators beziehungsweise der Aktuator-Einrichtung im Flächenschwerpunkt der Kontaktfläche zwischen den Substraten 1, 2. Die Anlage verfügt vorzugsweise über Sensoren zur Kraftüberwachung für eine Kontrolle der Druckbeaufschlagung.

In einer weiteren Ausführungsform ist der Druckstempel 6 als ein druckelastischer Stempel ausgeführt (beispielsweise durch eine Elastomerschicht), der besonders gleichmäßigen Druck beziehungsweise Flächenlast in den Substratstapel 3 einleitet. Der Druckstempel 6 kann vorzugsweise rund ausgeführt werden mit einer Stempeldruckfläche zwischen 0,5 mm² und 8000 mm², mit Vorzug zwischen 0,5 mm² und 2000 mm², mit größerem Vorzug zwischen 5 mm² und 500 mm².

Bei der Vorfixierung wird durch lokales Aufbringen von Kraft ein äquivalenter Druck für spontane Bonds in Teilflächen eingebracht, um die Substrate 1, 2 vorzufixieren (zu heften oder zu "tacken"). Die Substrate 1, 2 werden lokal vorgebondet. An den Teilflächen wird vorzugsweise ein kovalenter Bond erzeugt, der stark genug ist, um das geheftete Substratpaar 3 in eine Bondkammer G zu transferieren für eine ganzflächige Druckbeaufschlagung zum Bonden und optionalem Ausheizen. Das Ausrichtungsmodul F muss somit nur für die resultierende Kraft der Teilflächen ausgelegt werden.

Die obere Substrataufnahmeeinrichtung 4 kann transparent ausgeführt werden oder zusätzliche Ausnehmungen oder Einschnitte für Positionserfassungsmittel 5 aufweisen. Wird die obere Substrataufnahmeeinrichtung 4 transparent ausgeführt, sind bestimmte oder alle Bestandteile aus UV- und/oder IR-transparenten Materialien gefertigt. Die optische Transparenz dieser Materialien ist insbesondere größer als 0%, mit Vorzug größer als 20%, mit größerem Vorzug größer als 50%, mit größtem Vorzug größer als 80%, mit allergrößtem Vorzug größer als 95%.

Die obere Substrataufnahmeeinrichtung 4 kann darüber hinaus eine Aktuatorik für eine kontrollierte Z-Bewegung beinhalten. Zum einen, um die Substrate 1, 2 mit dem Roboterarm 9 zu beladen und dann einen optimalen Abstand für die Justierung einzustellen. Zum anderen, um die Substrate 1, 2 nach erfolgter Ausrichtung in Kontakt zu bringen. In einer alternativen Ausführungsform kann die Z-Bewegung über die Ausrichtungseinheit 7 ausgeführt werden.

Die Positionserfassungsmittel 5 können insbesondere Mikroskope zur Detektion der Position der Referenzmarken 1', 2' bezüglich X- und Y-Achse an mindestens zwei Punkten umfassen. Alternativ können die Positionserfassungsmittel 5 unter dem Substratpaar 3 angeordnet werden als Teil der Ausrichtungseinheit 7 oder neben der Ausrichtungseinheit 7. In einer weiteren Ausführungsform sind die Positionserfassungsmittel 5 neben den Substraten angeordnet, ungefähr in der Ebene der Berührungsfläche vom oberen Substrat 1 und unterem Substrat 2. Diese Ausführungsform ermöglicht die Detektion der Position der Substrate 1, 2 über die Erfassung der Kanten.

Die Ausrichtungseinheit 7 aus Figur 2 ermöglicht es, die Signale der Positionserfassungsmittel 5 in Justierbewegungen für das untere Substrat 2 umzusetzen. Entsprechend der Substrataufnahmeeinrichtung 4 für das obere Substrat 1 kann sie als Elektrostatik-Aufnahmeeinrichtung (engl. chuck) im Hochvakuum oder als mechanischer Aufnahmeeinrichtung ausgeführt werden. Bei der unteren Substrataufnahmeeinrichtung 8 kann darüber hinaus in einer weiteren Ausführungsform auch die reine Schwerkraft ausreichen, um eine Ausrichtung und Kontaktierung zu bewirken.

Die Ausrichtungseinheit 7 hat mindestens drei Bewegungsachsen: X-, Y- und eine Rotation um die Z-Achse. Optional kann in einer weiteren Ausführungsform eine Z-Achse auch Teil der Ausrichtungseinheit 7 sein mit der Funktion wie bei der oberen Substrataufnahmeeinrichtung 4 beschrieben. Weiter kann eine kontrollierte Kippmöglichkeit um die X- und Y-Achse vorgesehen werden, um die Substrate 1, 2 planparallel auszurichten vor dem Justiervorgang (Keilfehlerausgleich).

Die Positionserfassungsmittel 5 sorgen gemäß einer vorteilhaften Ausführungsform für die exakte Ausrichtung der Substrate 1, 2, indem sie die relativen Positionen erfassen und an die Steuerungseinheit weitergeben. Diese bewirkt eine Ausrichtung der Substrate 1, 2 zueinander. Die Ausrichtung erfolgt manuell oder bevorzugt automatisch mit einer Ungenauigkeit (engl. misalignment) von weniger als 100 µm, vorzugsweise weniger als 10 µm, noch bevorzugter weniger als 1 µm, mit aller größtem Vorzug weniger als 100 nm, am bevorzugtesten weniger als 10 nm.

Im Folgenden wird ein Ablauf einer Ausrichtung und Vorfixierung (Tacken) an Hand der Ausführungsform mit Druckstempel beschrieben:
1) Öffnen des Beladeventils 14,
2) Transfer des ersten Substrats 1 auf die Substrataufnahmeeinrichtung 4 und Fixierung des ersten Substrats 1 auf der ersten Substrataufnahmeeinrichtung 4,
3) Transfer des zweiten Substrats 2 auf die zweite Substrataufnahmeeinrichtung 8 und Fixierung des zweiten Substrats 2 auf der zweiten Substrataufnahmeeinrichtung 8,
4) Parallelausrichtung der Substrate 1, 2 über Aktuatoren in der Ausrichtungseinheit 7,
5) Einstellung eines Abstands (Justierspalts) zwischen den Substraten 1, 2. Der Justierspalt ist insbesondere kleiner als 100 µm, vorzugsweise kleiner als 50 µm, noch bevorzugter kleiner als 30 µm.
6) Ausrichtung der Substrate 1, 2 über Aktuatoren in der Ausrichtungseinheit 7 mittels der Positionsdetektion mit den Positionserfassungsmitteln 5 anhand der Referenzmarken 1', 2'; bevorzugt wird das zweite Substrat 2 relativ zum erster Substrat 1 ausgerichtet. Die Referenzmarken 1', 2' werden zueinander in Deckung gebracht oder in vorgegebene relative Positionen gefahren,
7) Vollflächige Kontaktierung der zu bondenden Substratoberflächen 1o, 2o der Substrate 1, 2 mit geringer Kontaktkraft; insbesondere liegt die Kontaktkraft zwischen 0.1 N und 500 N, mit Vorzug zwischen 0.5 N und 100 N, mit größerem Vorzug zwischen 1 N und 50 N, am bevorzugtesten zwischen 1 N und 10 N,
8) Kraftbeaufschlagung durch den Druckstempel 6 auf einer, insbesondere zentrischen, Teilfläche mit einem Durchmesser zwischen 1 und 100 mm, mit Vorzug zwischen 1 und 50 mm, mit größerem Vorzug zwischen 3 und 20 mm; Insbesondere liegt die Kraft zwischen 0.1 N und 5 kN, mit Vorzug zwischen 0.5 N und 1 kN, mit größerem Vorzug zwischen 1 N und 500 N, am bevorzugtesten zwischen 10 N und 50 N; der lokal hohe Druck bewirkt lokale kovalente Bonds und fixiert die Substrate 1, 2 relativ zueinander in Kontakt (Ausbildung des ausgerichteten Substratstapel 3),
9) Lösen des Substratstapels 3 vom oberen Substrathalter 4,
10) Entladen des Substratstapels 3 vom unteren Substrathalter 8 (beispielsweise über Beladestifte) mit dem Roboterarm 9,
11) Transfer des Substratstapels 3 über Ventil 14 zur Bondstation G und Bonden des Substratstapels 3.

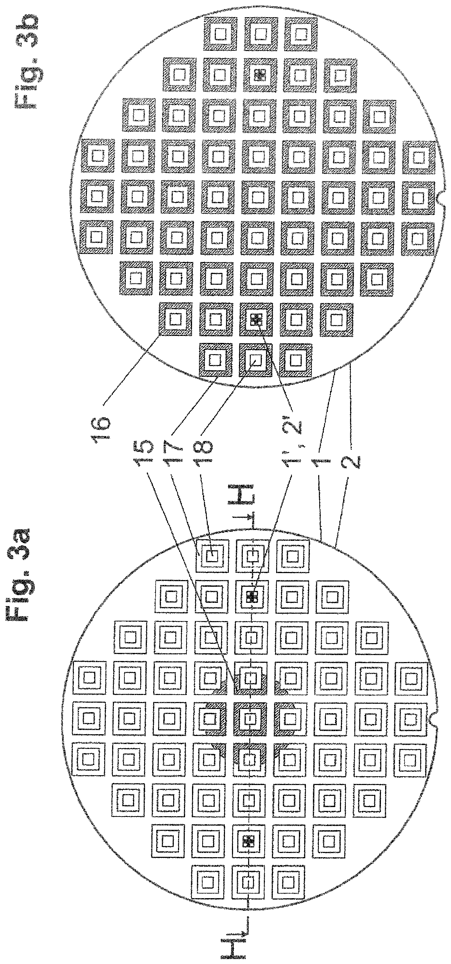

Figur 3a zeigt eine Aufsicht auf das zweite Substrat 2 des Substratstapels 3, wobei eine lokale Fläche 15 der am Substratstapel 3 nach der Ausrichtung durchgeführten Druckbeaufschlagung durch den Druckstempel 6 zu sehen ist. Diese Fläche entspricht einer vorfixierte (getackten) Zone 15 am Substratstapel 3.

Der Transfer des Substratstapels 3 zwischen Justiereinrichtung F mit Vorfixierung und Bondstation G erfolgt wieder über eine Transferkammer B. Die Bondstation G gemäß Figur 2 ermöglicht es, die teilflächige Vorfixierung in einen vollflächigen Bond zu verwandeln. Es wird dabei insbesondere eine hohe und gleichmäßige Flächenlast aufgebracht. Vorzugsweise liegt die Kraft zwischen 0,5 und 500 kN, mit Vorzug zwischen 0,5 und 250 kN, mit größerem Vorzug zwischen 0,5 und 200 kN, am bevorzugtesten zwischen 1 und 100 kN. Zusätzlich kann die Temperatur erhöht werden. Dabei liegt die Bondtemperatur vorzugsweise zwischen 18°C und 1100°C, mit Vorzug zwischen 18°C und 450°C, mir größerem Vorzug zwischen 18°C und 200°C, am bevorzugtesten bei Raumtemperatur. Die geringe Temperatur bei trotzdem sehr hoher Bondstärke wird durch den Effekt der Vorbehandlung erreicht und als Vorteil gesehen. CMOS Schaltkreise sollen nicht über 450°C, vorzugsweise nicht über 200°C, geheizt werden. Besondere Anwendungen wie beispielsweise das Bonden zweier Halbleitermaterialien mit sehr unterschiedlicher thermischer Dehnung (beispielsweise Si mit GaAs) erfolgen vorzugsweise bei niedrigen Temperaturen, bevorzugt Raumtemperatur, um nachfolgende mechanische Spannungen und Verbiegungen zu vermeiden.

Ein Druckstempel 11 der Bondstation G ist mit einem Kraftaktuator 12 verbunden und leitet eine gleichmäßige Flächenlast in den Substratstapel 3 ein. Zur gleichmäßigen Verteilung der Flächenlast können duktile (verformbare) Schichten eingebaut werden wie beispielsweise flexibler Graphit, Gummi- und/oder Silikonmatten.

Bevorzugte Kraftbereiche des Kraftaktuators 12 liegen zwischen 0,5 und 500 kN, mit Vorzug zwischen 0,5 und 250 kN, mit größerem Vorzug zwischen 0,5 und 200 kN, am bevorzugtesten zwischen 1 und 100 kN. Der Kraftaktuator 12 kann insbesondere ein Pneumatikzylinder, Hydraulikzylinder, Elektrospindelantrieb oder Kniehebelantrieb sein (nicht dargestellt). Vorteilhafte Ausführungen beinhalten ein Messmittel zur Regelung der Kraft, insbesondere um diese programmiert zu steigern, konstant zu halten und später wieder abzubauen. Die Anlage verfügt vorzugsweise über Sensoren zur Kraftüberwachung.

Der vorfixierte Substratstapel 3 wird auf die Substrataufnahme 13 übergeben, insbesondere über Beladestifte (nicht dargestellt). Die Substrataufnahme 13 hat vorzugsweise, um einen Substratstapel 3 auf der Halterung aufzunehmen und abzulegen oder einen abgelegten Substratstapel 3 von der Halterung wegzuheben, in der Halterung einen Hebemechanismus mit Ladestiften. Dabei wird der Substratstapel 3 mit Hilfe von, im Probenhalter befindlichen Stiften (Pins) angehoben, sodass ein, insbesondere als Roboterarm ausgebildeter, Robotergreifer (Paddle) unterhalb oder seitlich des Substratstapels fahren kann und diesen mit einer beispielsweise Aufwärtsbewegung von den Stiften entnimmt. Die Substrataufnahme 13 kann rein über Schwerkraft erfolgen. In einer vorteilhaften Ausführungsform wird der Waferstapel 3 durch eine elektrostatische Fixierung an der Substrataufnahme 13 fixiert. Diese elektrostatische Fixierung kann sicherstellen, dass am Bondprozessende beim Lösen der Kontaktkraft der gebondete Substratstapel 3 an der bevorzugt unteren Substrataufnahme 13 verbleibt. Optional verfügt die Substrataufnahme 13 über eine Heizeinrichtung (nicht dargestellt) beziehungsweise über eine Heiz- und/oder Kühleinrichtung.

Im Folgenden wird ein bevorzugter Ablauf für den finalen Bondschritt in der Bondstation G beschrieben:
1) Transfer des vorfixierten Substratstapels 3 über das Ventil 14 auf die untere Substrataufnahme 13, insbesondere über die Beladestifte,
2) Fixieren des Substratstapels 3 an der Substrataufnahme 13, insbesondere über eine elektrostatische Haltevorrichtung,
3) Einleiten einer Bondkraft über den Kraftaktuator 12 und den Druckstempel 11,
4) Optional: Aufheizen durch, insbesondere symmetrische und doppelseitige, Beheizung,
5) Halten der Bondkraft und optional der Temperatur (durch die eingeleitete gleichmäßige Kraft schließen sich alle Mikrokavitäten zwischen den Substratoberflächen 1o, 2o, wodurch ein kovalenter Bond über die gesamte Substratfläche ausgebildet wird)
6) Optional Abkühlen,
7) Lösen der Bondkraft,
8) Entladen des Substratstapels 3 von der Substrataufnahme 13, insbesondere über Beladestifte,
9) Transfer des gebondeten Substratstapels 3 durch das Ventil 14 und über den Roboterarm 9 (Transferkammer B)

Das Ventil 14 beziehungsweise Schleusentor ist einer erfindungsgemäß bevorzugten Ausführungsform ein Gate Valve, insbesondere ein Ultrahochvakuum Gate Valve, zum Transfer der Substrate 1, 2 beziehungsweise des Substratstapels 3.

Die Ausrichtungsgenauigkeit der gebondeten Substrate nach der Vorfixierung sowie nach dem Bonden ist vorzugsweise kleiner als 100 µm, mit Vorzug kleiner als 10 µm, mit größerem Vorzug kleiner als 5 µm, am bevorzugtestem kleiner als 2 µm, mit allergrößtem Vorzug kleiner als 1 µm, noch bevorzugter <100 nm.

Die angestrebte Bondstärke für den finalen, vollflächigen Bond ist mit Vorzug größer als 1 J/m², bevorzugt größer als 1,5 J/m², mit größerem Vorzug größer als 2 J/m².

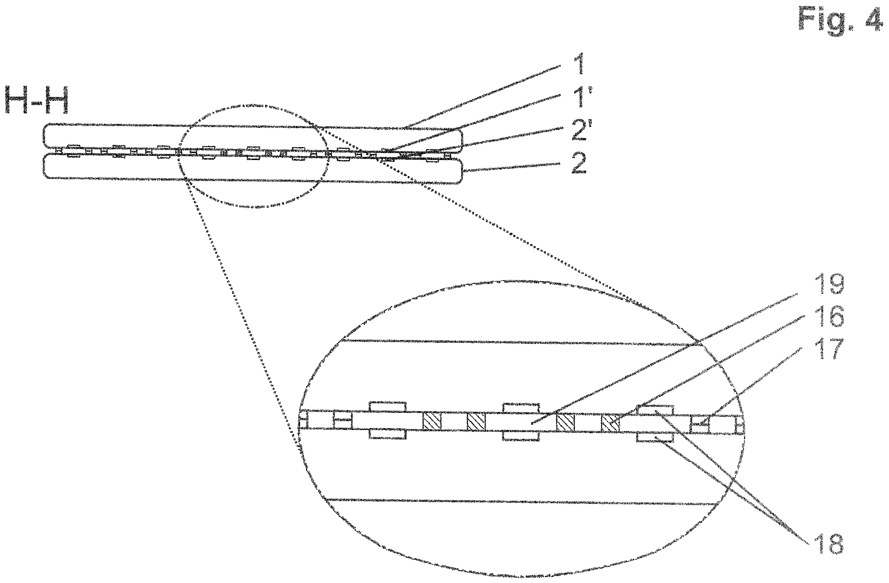

Der tatsächlich zu bondende Bereich entspricht nicht immer die Gesamtfläche der Substrate 1, 2. Wie in den Figuren 3b und 4 dargestellt, sind die Bondflächen vom Aufbau der Substrate 1, 2 abhängig. Bei der Ausführungsform gemäß Figur 3b bilden Dichtrahmen um jede Struktur beziehungsweise Baugruppe (engl. device) des Substratstapels 3 eine Bondfläche 17. Diese Methode wird für MEMS angewendet. Figur 3b zeigt die gebondete Zone 16.

Figur 4 zeigt eine Querschnittsansicht gemäß Schnittlinie H-H aus Figur 3a. Die Querschnittsansicht des gebondeten Substratstapels 3 gemäß Figur 4 zeigt insbesondere die gebondeten Zonen 16 (Dichtrahmen), die tatsächlichen Bondflächen 17, Strukturen 18 der Produktsubstrate 1, 2 (engl. devices) und einen nichtgebondeten interstrukturellen Raum 19.

Besonders Vorteilhafte Bondprozesse für diese Erfindung sind:
- Hermetisch dichte Hochvakuumbonds (Hochvakuum in einer Kavität des Substrats permanent abdichten)
- Elektrisch leitfähige Bondverbindungen
- Optisch transparente Bondverbindungen

Bei dreidimensionaler (3D) Integration von Mikroelektronik sind ganzflächige Bonds bevorzugt, insbesondere zwischen Siliziumdioxid (SiO2)-Flächen, beziehungsweise auch simultan mit Kupfer (Cu) und Si02 bei sogenannten Hybridbonds. Bei diesem Ausführungsbeispiel entspricht die Bondfläche der gesamten Substratfläche.

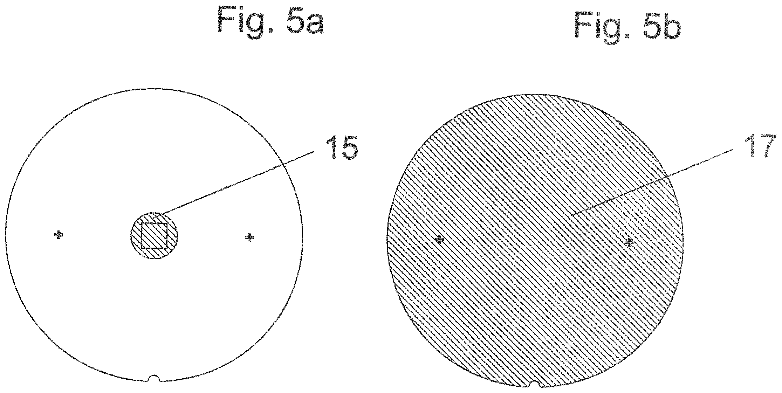

Figur 5a zeigt eine Aufsicht auf das untere Produktsubstrat 2 eines Substratstapels 3, wobei die lokale Fläche 15 der am Substratstapel 3 nach der Ausrichtung durchgeführten Druckbeaufschlagung durch den Druckstempel zu sehen ist. Diese Fläche entspricht der vorgebondeten (getackten) Zone 15 am Substratstapel.

Figur 5b zeigt die nach dem ganzflächigen Bonden resultierende tatsächliche Bondfläche 17.

### Bezugszeichenliste

- 1, 2: Substrate
- 1o, 2o: Substratoberflächen
- 1',2': Referenzmarken
- 3: Substratstapel
- 4: erste Substrataufnahme
- 5: Positionserfassungsmittel
- 6: Druckstempel
- 7: Ausrichtungseinheit
- 8: zweite Substrataufnahme
- 9: Roboterarm
- 10: Transferkammer
- 11: Druckstempel
- 12: Kraftaktuator
- 13: Substrataufnahme
- 14: (Belade-)Ventil
- 15: Vorfixierte (Getackte) Zone
- 16: Gebondete Zone
- 17: Bondfläche
- 18: Strukturen
- 19: interstruktureller Raum
- 20: Arbeitsraum
- a: Transfer-Schritt ohne das Vakuum wesentlich zu verändern.
- b: Transfer von oder nach Umgebungsdruck
- c: Kraftvektor
- d: Gebondete Fläche
- k: Hochvakuumumgebung
- A: Schleuse
- B: Transferkammer
- C: Vorjustiereinrichtung
- D: Vorbehandlungsstation
- E: Wendestation
- F: Ausrichtungsmodul mit Vorfixierungseinrichtung
- G: Bondstation
- M: Mitte des Substrats bzw. des Substratstapels

## Patentansprüche

1. Verfahren zur Vorfixierung von Substraten (1, 2), wobei mindestens eine Substratoberfläche (1o, 2o) der Substrate (1, 2) in mindestens einem Oberflächenbereich vorbehandelt, insbesondere amorphisiert, ist, **dadurch gekennzeichnet, dass** die Substrate (1, 2) ausgerichtet und anschließend an den vorbehandelten Oberflächenbereichen kontaktiert und vorfixiert werden.

2. Verfahren nach Anspruch 1, bei dem das Ausrichten und die Vorfixierung in einer ersten Modulkammer erfolgen, insbesondere bei einem Druck von weniger als 1 bar, vorzugsweise weniger als 1 mbar, noch bevorzugter weniger als 10e⁻⁵ mbar, noch bevorzugter weniger als 10e⁻⁶ mbar, noch bevorzugter weniger als 10e⁻⁷ mbar, noch bevorzugter weniger als 10e^{- 8} mbar.

3. Verfahren nach einem der vorhergehenden Ansprüche, bei dem das Ausrichten mit einer Ausrichtungsgenauigkeit weniger als 100 µm, insbesondere weniger als 10 µm, vorzugsweise weniger als 1 µm, noch bevorzugter weniger als 100 nm, am bevorzugtesten weniger als 10 nm, erfolgt.

4. Verfahren nach einem der vorhergehenden Ansprüche, bei dem die Vorfixierung eine Bindungsfestigkeit zwischen 0.01 J/m² und 5 J/m², mit Vorzug größer als 0,1 J/m², bevorzugter größer als 0,2 J/m², noch bevorzugter größer als 0,5 J/m², am bevorzugtesten größer als 1 J/m², mit allergrößtem Vorzug größer als 1,5 J/m² aufweist.

5. Verfahren nach einem der vorhergehenden Ansprüche, bei dem die Vorfixierung durch lokale Energiezufuhr, insbesondere von einer der zu kontaktierenden Substratoberfläche (1o, 2o) abgewandten Seite her, erfolgt.

6. Verfahren nach einem der vorhergehenden Ansprüche, bei dem mindestens eine der Substratoberflächen (1o, 2o), vorzugsweise alle, einen Mittenrauwert Ra kleiner als 20 nm, bevorzugter einen Mittenrauwert Ra kleiner als 1 nm, aufweist.

7. Verfahren nach einem der vorhergehenden Ansprüche, bei dem die Substrate (1,2) ausschließlich an den vorbehandelten Oberflächenbereichen vorfixiert werden.

8. Verfahren nach einem der vorhergehenden Ansprüche, bei dem die Substrate (1,2) durch ein lokales Aufbringen von Energie, insbesondere Kraft und/oder Wärme, vorfixiert werden.

9. Verfahren nach einem der vorhergehenden Ansprüche, bei dem zur Vorfixierung Wärme lokal, insbesondere gepulst, an einer Kontaktfläche eingebracht wird, wobei zur Erzeugung der Wärme insbesondere elektrische Felder, magnetische Felder oder elektromagnetische Strahlung, vorzugsweise Laser, genutzt wird, wobei der Laser insbesondere eine Wellenlänge besitzt, die für eine optimale Erhitzung mindestens eines Materials im Substratstapel sorgt, wobei die Wellenlänge vorzugsweise im Bereich zwischen 1 nm und 1 mm liegt, noch bevorzugter zwischen 200 nm und 1 mm, noch bevorzugter zwischen 400 nm und 1 mm, am bevorzugtesten zwischen 600 nm und 1 mm, am allerbevorzugtesten zwischen 800 nm und 1 mm, wobei der Laser vorzugsweise ein Infrarotlaser ist, wobei der Durchmesser des Laserstrahls insbesondere kleiner als 10 mm ist, vorzugsweise kleiner als 5 mm, noch bevorzugter kleiner als 2 mm, am bevorzugtesten kleiner als 1 mm, am allerbevorzugtesten kleiner als 0.5 mm, wobei die Laserleistung insbesondere größer als 10 W ist, vorzugsweise größer als 100 W, noch bevorzugter größer als 1000 W, am bevorzugtesten größer als 0.01 MW.

10. Verfahren nach einem der vorhergehenden Ansprüche, bei dem zur Vorfixierung ein, möglichst exakt fokussierbarer, Laser verwendet wird, wobei kohärentes Laserlicht durch Optiken vorzugsweise in einem Fokus gebündelt wird, der sich zwischen den Substraten, also in einer Verbindungsschicht, befindet, wodurch eine örtlich möglichst begrenzte, intensive und schnelle Erwärmung der Verbindungsschicht bewirkt wird.

11. Verfahren nach einem der vorhergehenden Ansprüche, bei dem für die Handhabung, insbesondere den Transport von einem Ausrichtungsmodul beziehungsweise Vorfixierungsmodul zu einem Bondmodul oder anderen Bearbeitungsmodulen, auf eine Aufnahmeeinrichtung auf einer der beiden oder auf beiden Halteseiten eines Substratstapels verzichtet werden kann.

12. Verfahren zum permanenten Bonden der nach einem der vorhergehenden Ansprüche vorfixierten Substrate (1, 2) an den Substratoberflächen (1o, 2o).

13. Verfahren nach Anspruch 12, bei dem das Bonden in einer zweiten, insbesondere mit der ersten Moduikammer durch eine Schleuse verbundene, Modulkammer erfolgt.

14. Verfahren nach Anspruch 12 oder 13, bei dem ein Transport der vorfixierten Substrate (1, 2) mit einem Roboterarm und ohne eine Aufnahmeeinrichtung zur Auflage der vorfixierten Substrate (1, 2) erfolgt.

15. Vorrichtung zur Vorfixierung von Substraten (1, 2) mit
- mindestens einer Vorbehandlungseinrichtung zur Vorbehandlung mindestens einer Substratoberfläche (1o, 2o) der Substrate (1, 2) in mindestens einem Oberflächenbereich,
- einer Ausrichtungseinrichtung zur Ausrichtung der Substrate (1, 2) und
einer der Ausrichtungseinrichtung nachgeordneten Vorfixierungseinrichtung zur Kontaktierung und Vorfixierung der ausgerichteten Substraten (1, 2) an den vorbehandelten, insbesondere amorphisierten, Oberflächenbereichen.

16. Vorrichtung nach Anspruch 15, wobei die Vorfixierung in einem separaten Vorfixierungsmodul erfolgt.
